# EUROPEAN PATENT APPLICATION

(11) **EP 4 811 961 A1**
(43) Date of publication of application: **23.09.2026**
(21) Application number: 26151482.2
(22) Date of filing: 13.01.2026
(51) Int. Cl.: H10D 84/80, H10D 30/66, H10D 84/00, H10D 30/01, H10D 84/01, H10D 89/60, H10D 62/10, H10D 62/13

(54) **SEMICONDUCTOR STRUCTURE AND MANUFACTURING METHOD THEREOF**

(30) Priority: 19.03.2025 CN 202510326540
(71) Applicant: Diodes Incorporated, Plano, Texas 75024 (US)
(72) Inventor: KUO, Ta-Chuan, 231023 NEW TAIPEI CITY (TW); CHUANG, Chiao-Shun, 231023 NEW TAIPEI CITY (TW)
(74) Representative: Marks & Clerk LLP

(57) **Abstract**

A semiconductor structure includes an epitaxial layer on a substrate and a doped region extending from the top surface of the epitaxial layer into the epitaxial layer. A gate structure extends from the top surface of the doped region into the epitaxial layer. The gate structure includes a first polysilicon structure, a gate oxide layer surrounding the first polysilicon structure, a second polysilicon structure over the first polysilicon structure and the gate oxide layer, and an insulating layer, which separates the first polysilicon structure and the gate oxide layer from the second polysilicon structure and surrounds the second polysilicon structure, and extends between the top surface of the epitaxial layer and a diode string disposed over the epitaxial layer. A source structure adjoins the doped region and the second polysilicon structure, and is electrically coupled to the diode string. A method of manufacturing the semiconductor structure is also provided.

## Description

### CROSS-REFERENCE TO RELATED APPLICATIONS

This patent application claims priority to China Patent Application No. 202510326540.7, filed on March 19, 2025 and entitled "SEMICONDUCTOR STRUCTURE AND MANUFACTURING METHOD THEREOF," which is hereby incorporated by reference herein as if reproduced in its entirety.

### TECHNICAL FIELD

The present disclosure relates generally to the field of semiconductors, and in particular embodiments, to techniques and mechanisms of a semiconductor structure and a manufacturing method of the semiconductor structure. In some embodiments, a semiconductor structure having an electrostatic discharge protection structure and a trench gate structure, and a manufacturing method thereof are provided.

### BACKGROUND

As the sizes of semiconductor structures shrink, the distance between components is greatly reduced, however, the risk of electrostatic discharge (ESD) and leakage is increased. In some existing technologies, trench gate structures are used to help shrink the sizes of semiconductor structures, and electrostatic discharge protection structures are configured to reduce the risk of damaging semiconductor structures by instantaneous large currents. However, such configurations greatly increase the complexity and cost of manufacturing semiconductor structures. Therefore, how to efficiently arrange the manufacturing process has become an important consideration in this field. It is also desirable to develop mechanisms and methods to improve the manufacturing process of semiconductor structures having such configurations.

### SUMMARY

Embodiments of the present disclosure relate to a semiconductor structure. The semiconductor structure includes a substrate, an epitaxial layer, a diode string, a gate structure, and a source structure. The epitaxial layer is on the substrate. The epitaxial layer has a doped region. The doped region extends from the top of the epitaxial layer toward the substrate. The diode string is above the epitaxial layer. The gate structure is at least partially surrounded by the doped region and extends toward the substrate into the epitaxial layer. The gate structure includes a first polysilicon structure, a gate oxide layer, an insulating layer, and a second polysilicon structure. The gate oxide layer surrounds the polysilicon structure. The insulating layer is above the first polysilicon structure and the gate oxide layer, and extends between the doped region and the diode string. The second polysilicon structure is above the first polysilicon structure and the gate oxide layer and is surrounded by the insulating layer. The source structure adjoins the doped region and the second polysilicon structure, and is electrically coupled to the diode string through a first conductive plug.

Optionally, in the preceding embodiment, the doped region comprises: a first lightly doped region; a second lightly doped region, above the first lightly doped region; and a heavily doped region, disposed on the first lightly doped region and surrounded by the second lightly doped region, wherein the source structure adjoins the second lightly doped region and the heavily doped region, and the doping concentration of the second lightly doped region is less than the doping concentration of the heavily doped region and greater than the doping concentration of the first lightly doped region.

Optionally, in any of the preceding applicable embodiments, the second lightly doped region and the heavily doped region are electrically connected to a source electrode and together serve as the source structure.

Optionally, in any of the preceding applicable embodiments, the gate structure further comprises a thermal oxide layer, wherein the thermal oxide layer comprises: a bottom portion above the first polysilicon structure; and a sidewall portion extending between the doped region and the insulating layer.

Optionally, in any of the preceding applicable embodiments, a thickness of the insulating layer is greater than a thickness of the thermal oxide layer.

Optionally, in any of the preceding applicable embodiments, a thickness of the bottom portion is greater than a thickness of the sidewall portion.

Optionally, in any of the preceding applicable embodiments, the bottom portion does not contact the sidewall portion.

Optionally, in any of the preceding applicable embodiments, the diode string comprises: a plurality of first doped regions having a first conductivity type, wherein the first conductive plug adjoins a first end of the plurality of first doped regions; and a plurality of second doped regions of a second conductivity type, wherein the plurality of first doped regions and the plurality of second doped regions are alternately arranged, a PN junction is formed at an interface between each first doped region and an adjacent second doped region.

Optionally, in any of the preceding applicable embodiments, the second polysilicon structure has the second conductivity type.

Optionally, in any of the preceding applicable embodiments, the plurality of second doped regions is made of polysilicon, and a doping concentration of the plurality of second doped regions is same as a doping concentration of the second polysilicon structure.

Optionally, in any of the preceding applicable embodiments, the semiconductor structure further comprises: a gate electrode, above the diode string, electrically coupled to the first polysilicon, and coupled to a second end of the plurality of first doped regions through a second conductive plug.

Optionally, in any of the preceding applicable embodiments, the semiconductor structure further comprises: an interlayer oxide layer, on the insulating layer, surrounding the source structure and the diode string, and covering the diode string.

Optionally, in any of the preceding applicable embodiments, a thickness of the insulating layer on the first polysilicon structure is less than a thickness of a portion of the insulating layer extending between the doped region and the diode string.

Optionally, in any of the preceding applicable embodiments, the thickness of the portion of the insulating layer extending between the doped region and the diode string is between about 300 angstroms and about 10,000 angstroms.

Optionally, in any of the preceding applicable embodiments, the source structure comprises: the first conductive plug; a source electrode; a metal layer disposed on two sides of the source electrode; and a barrier metal layer, surrounding the source electrode, the metal layer and the first conductive plug, and adjoining the doped region, the second polysilicon structure and the diode string.

Optionally, in any of the preceding applicable embodiments, the first conductive plug and the metal layer have a same material.

Optionally, in any of the preceding applicable embodiments, the second polysilicon structure has a rectangular profile in a cross-sectional view.

Optionally, in any of the preceding applicable embodiments, the second polysilicon structure has a triangular profile in a cross-sectional view.

Optionally, in any of the preceding applicable embodiments, in a cross-sectional view, the second polysilicon structure has an arc-shaped sidewall adjoining the insulating layer.

Embodiments of the present disclosure relate to a method for manufacturing a semiconductor structure. The method comprises: providing a substrate, wherein the substrate has an epitaxial layer thereon, and the epitaxial layer has a first lightly doped region extending from a top of the epitaxial layer toward the substrate; forming a trench extending from a top surface of the first lightly doped region toward the substrate, beyond the first lightly doped region and into the epitaxial layer; forming a gate oxide layer surrounding a first polysilicon structure in the trench; forming an insulating layer above the first polysilicon structure and the gate oxide layer and extending to the top surface of the first lightly doped region; forming a polysilicon layer above the insulating layer, wherein the polysilicon layer fills a remaining space of the trench; removing a portion of the polysilicon layer to simultaneously form a second polysilicon structure in the trench and a third polysilicon structure on the top surface of the first lightly doped region; converting a portion of the third polysilicon structure into a plurality of first doped regions having a first conductivity type, wherein a remaining portion of the third polysilicon structure is a plurality of second doped regions having a second conductivity type, and the plurality of first doped regions and the plurality of second doped regions are alternately arranged to form a diode string; forming an interlayer oxide layer on the insulating layer and the second polysilicon structure, surrounding the diode string and covering the diode string; and forming a source electrode extending through the interlayer oxide layer and adjoining the second polysilicon structure.

Optionally, in the preceding embodiment, the step of converting the portion of the third polysilicon structure into the plurality of first doped regions having the first conductivity type comprise performing an ion implantation process, wherein the step of performing the ion implantation process further converts a first portion of the first lightly doped region into a second lightly doped region, and a doping concentration of the second lightly doped region is greater than a doping concentration of the first lightly doped region.

Optionally, in any of the preceding applicable embodiments, the method may further include converting a second portion of the first lightly doped region into a heavily doped region, wherein the heavily doped region is surrounded by the second lightly doped region, and a top surface of the heavily doped region is coplanar with a top surface of the second lightly doped region.

Optionally, in any of the preceding applicable embodiments, a doping concentration of the heavily doped region is greater than the doping concentration of the second lightly doped region, the second lightly doped region has the first conductivity type, and the heavily doped region and the first lightly doped region have the second conductivity type.

Optionally, in any of the preceding applicable embodiments, the source electrode adjoins the second lightly doped region and the heavily doped region.

Optionally, in any of the preceding applicable embodiments, the method may further include forming a gate electrode on the interlayer oxide layer, wherein the source electrode is electrically coupled to a first end of the plurality of first doped regions, and the gate electrode is electrically coupled to a second end of the plurality of first doped regions.

Optionally, in any of the preceding applicable embodiments, the step of removing the portion of the polysilicon layer comprises performing an anisotropic etching process, wherein the step of performing the anisotropic etching process further removes a portion of the insulating layer.

Optionally, in any of the preceding applicable embodiments, after the step of performing the anisotropic etching process, a thickness of the insulating layer below the third polysilicon structure is greater than a thickness of the insulating layer not covered by the third polysilicon structure.

Optionally, in any of the preceding applicable embodiments, the method may further include, before forming the insulating layer, performing a thermal oxidation process to form a thermal oxidation layer on the first polysilicon structure and the first lightly doped region.

Optionally, in any of the preceding applicable embodiments, the step of performing the thermal oxidation process comprises: consuming a portion of the first polysilicon structure to form a bottom portion of the thermal oxide layer; and consuming a portion of the first lightly doped region to form a sidewall portion of the thermal oxide layer.

Optionally, in any of the preceding applicable embodiments, the bottom portion does not contact the sidewall portion, and the insulating layer is at least partially not covered by the thermal oxide layer.

Optionally, in any of the preceding applicable embodiments, the insulating layer is formed in a manner different from the thermal oxidation process.

According to one aspect of the present disclosure, a semiconductor structure is provided that includes: an epitaxial layer on a substrate, the epitaxial layer comprising a doped region extending from a top surface of the epitaxial layer into the epitaxial layer; a diode string over the epitaxial layer; and a gate structure, extending from the top surface of the epitaxial layer into the epitaxial layer passing through the doped region. The gate structure comprises: a first polysilicon structure; a gate oxide layer surrounding the first polysilicon structure; a second polysilicon structure over the first polysilicon structure and the gate oxide layer; and an insulating layer, comprising a first portion surrounding the second polysilicon structure and between the second polysilicon structure and the first polysilicon structure and the gate oxide layer, and a second portion extending between the top surface of the epitaxial layer and the diode string.

Optionally, in any of the preceding applicable embodiments, the doped region comprises: a first lightly doped region; a second lightly doped region in the first lightly doped region; and a heavily doped region, disposed in the first lightly doped region and surrounded by the second lightly doped region; and wherein a doping concentration of the second lightly doped region is less than a doping concentration of the heavily doped region and greater than a doping concentration of the first lightly doped region.

Optionally, in any of the preceding applicable embodiments, the second lightly doped region and the heavily doped region are electrically connected to a source electrode, and serve with the source electrode as a source structure of the semiconductor structure.

Optionally, in any of the preceding applicable embodiments, the gate structure further comprises a thermal oxide layer, and the thermal oxide layer comprises: a first portion on the first polysilicon structure; and a second portion extending between the top surface of the epitaxial layer and the second portion of the insulating layer.

Optionally, in any of the preceding applicable embodiments, a thickness of the first portion of the thermal oxide layer is greater than a thickness of the second portion of the thermal oxide layer.

Optionally, in any of the preceding applicable embodiments, the first portion of the thermal oxide layer is not in contact with the second portion of the thermal oxide layer.

Optionally, in any of the preceding applicable embodiments, the diode string comprises: a plurality of first doped regions of a first conductivity type; and a plurality of second doped regions of a second conductivity type; and wherein the plurality of first doped regions and the plurality of second doped regions are alternately arranged, and a PN junction is formed at an interface between each first doped region and an adjacent second doped region.

Optionally, in any of the preceding applicable embodiments, the plurality of second doped regions is made of polysilicon, and a doping concentration of the plurality of second doped regions is same as a doping concentration of the second polysilicon structure.

Optionally, in any of the preceding applicable embodiments, a thickness of the first portion of the insulating layer on the first polysilicon structure is less than a thickness of the second portion of the insulating layer.

Optionally, in any of the preceding applicable embodiments, the thickness of the second portion of the insulating layer is between about 300 angstroms and about 10,000 angstroms.

Optionally, in any of the preceding applicable embodiments, in a cross-sectional view, the second polysilicon structure has a rectangular profile, a triangular profile, or an arc-shaped sidewall.

According to another aspect of the present disclosure, a method is provided that includes: forming an epitaxial layer on a substrate, the epitaxial layer comprising a first lightly doped region extending from a top surface of the epitaxial layer toward the substrate; forming a trench extending from a top surface of the first lightly doped region into the epitaxial layer; forming, in the trench, a first polysilicon structure and a gate oxide layer surrounding the first polysilicon structure; forming an insulating layer on the first polysilicon structure and the gate oxide layer in the trench, and on the top surface of the first lightly doped region; forming a polysilicon layer disposed on the insulating layer into a second polysilicon structure in the trench and a third polysilicon structure over the top surface of the first lightly doped region simultaneously; forming the third polysilicon structure into a plurality of first doped regions of a first conductivity type and a plurality of second doped regions of a second conductivity type, the plurality of first doped regions and the plurality of second doped regions being alternately arranged and forming a diode string; and forming a source electrode over the first lightly doped region and adjoining the second polysilicon structure.

Optionally, in any of the preceding applicable embodiments, forming the polysilicon layer disposed on the insulating layer into the second polysilicon structure in the trench and the third polysilicon structure over the top surface of the first lightly doped region comprises: forming the polysilicon layer on the insulating layer covering the trench and the first lightly doped region; disposing a mask on the polysilicon layer; and removing a portion of the polysilicon layer that is above the top surface of the first lightly doped region and not covered by the mask, a first remaining portion of the polysilicon layer in the trench forming the second polysilicon structure, and a second remaining portion of the polysilicon layer covered by the mask forming the third polysilicon structure.

Optionally, in any of the preceding applicable embodiments, removing the portion of the polysilicon layer comprises: performing an anisotropic etching process to remove the portion of the polysilicon layer, wherein the anisotropic etching process further removes a portion of the insulating layer not covered by the mask.

Optionally, in any of the preceding applicable embodiments, a top surface of the insulating layer in the trench is lower than the top surface of the first lightly doped region, and the insulating layer is further formed on a portion of sidewalls of the trench above the first polysilicon structure and the gate oxide layer.

Optionally, in any of the preceding applicable embodiments, forming the third polysilicon structure into the plurality of first doped regions and the plurality of second doped regions comprises: performing an ion implantation process to form a portion of the third polysilicon structure into the plurality of first doped regions, with a remaining portion of the third polysilicon structure forming the plurality of second doped regions.

Optionally, in any of the preceding applicable embodiments, performing the ion implantation process further forms a first portion of the first lightly doped region into a second lightly doped region, a doping concentration of the second lightly doped region being greater than a doping concentration of the first lightly doped region.

Optionally, in any of the preceding applicable embodiments, the method further comprises: forming a second portion of the first lightly doped region into a heavily doped region, wherein the heavily doped region is surrounded by the second lightly doped region, and a top surface of the heavily doped region is coplanar with a top surface of the second lightly doped region.

Optionally, in any of the preceding applicable embodiments, the method further comprising: forming a gate electrode over the first lightly doped region, wherein the source electrode is electrically coupled to a first end of the plurality of first doped regions, and the gate electrode is electrically coupled to a second end of the plurality of first doped regions.

According to another aspect of the present disclosure, a semiconductor structure is provided that includes: a substrate; an epitaxial layer on the substrate; a doped region in the epitaxial layer, the doped region extending from a top surface of the epitaxial layer toward the substrate; a diode string over the doped region, the diode string comprising a plurality of first doped regions and a plurality of second doped regions alternately arranged; and a gate structure, extending from a top surface of the doped region into the epitaxial layer. The gate structure comprises: a first polysilicon structure; a gate oxide layer surrounding the first polysilicon structure; a second polysilicon structure over the first polysilicon structure and the gate oxide layer, a top surface of the second polysilicon structure being coplanar with the top surface of the doped region; an insulating layer, comprising: a first portion disposed between the second polysilicon structure and the first polysilicon structure and the gate oxide layer, and surrounding the second polysilicon structure, and a second portion extending between the top surface of the doped region and the diode string; and a thermal oxide layer comprising: a first portion on the first polysilicon structure between the first polysilicon structure and the second polysilicon structure, a second portion on sidewalls of the gate structure, the second portion not in contact with the first portion of the thermal oxide layer, and a third portion between the top surface of the doped region and the second portion of the insulating layer.

### BRIEF DESCRIPTION OF THE DRAWINGS

Aspects of several embodiments of the present disclosure may be best understood when the following detailed description is read in conjunction with the accompanying drawings. It should be noted that various structures may not be drawn to scale. In fact, the dimensions of the various structures may be arbitrarily enlarged or reduced for clarity of discussion.
FIG. 1 is a circuit diagram of a semiconductor structure according to some embodiments of the present disclosure;
FIG. 2 is a schematic diagram of the semiconductor structure according to some embodiments of the present disclosure;
FIG. 3 is a top view of the semiconductor structure according to some embodiments of the present disclosure;
FIG. 4 is a cross-sectional view of the semiconductor structure according to some embodiments of the present disclosure;
FIG. 5 to FIG. 24 are schematic diagrams of a semiconductor structure in various stages of a manufacturing process according to some embodiments of the present disclosure;
FIG. 25 is a schematic diagram of another semiconductor structure according to embodiments of the present disclosure;
FIG. 26 is a schematic diagram of yet another semiconductor structure according to embodiments of the present disclosure;
FIG. 27 is a schematic diagram of yet another semiconductor structure according to embodiments of the present disclosure; and
FIG. 28 is a flowchart of a method of manufacturing a semiconductor structure according to embodiments of the present disclosure.

The same or similar components are marked with the same reference numerals in the drawings and the detailed description. Embodiments of the present disclosure will be readily understood from the following detailed description in conjunction with the accompanying drawings.

### DETAILED DESCRIPTION OF ILLUSTRATIVE EMBODIMENTS

The making and using of embodiments of this disclosure are discussed in detail below. It should be appreciated, however, that the concepts disclosed herein can be embodied in a wide variety of specific contexts, and that the specific embodiments discussed herein are merely illustrative and do not serve to limit the scope of the claims. Further, it should be understood that various changes, substitutions and alterations can be made herein without departing from the spirit and scope of this disclosure as defined by the appended claims.

Furthermore, one or more features from one or more of the following described embodiments may be combined to create alternative embodiments not explicitly described, and features suitable for such combinations are understood to be within the scope of this disclosure. It is therefore intended that the appended claims encompass any such modifications or embodiments.

The following disclosure provides various different embodiments or examples for implementing different features of the presented subject matter. Specific embodiments of components and configurations are described below. Certainly, these are examples only and are not intended to be limiting. In this disclosure, references to forming a first feature over or on a second feature may include embodiments where the first and second features are formed in direct contact, and may also include embodiments where an additional feature is formed between the first feature and the second feature such that the first feature and the second feature may not be in direct contact. In addition, the present disclosure may repeat reference signs and/or letters in various embodiments. Such repetition is for simplicity and clarity and does not in itself indicate relationships between the various embodiments and/or configurations discussed.

The following is a detailed discussion of embodiments of the present disclosure. However, it should be understood that the present disclosure provides applicable concepts that can be embodied in a variety of specific contexts. The specific embodiments discussed are merely illustrative and do not limit the scope of the present disclosure.

Embodiments of the present disclosure provide a semiconductor structure and a manufacturing method for the same. In the semiconductor structure, a polysilicon structure is used to replace a cap layer on the top of a gate structure, and the polysilicon structure may be formed simultaneously with the polysilicon structure in an electrostatic discharge structure using the same semiconductor process. In other words, forming the polysilicon structure to replace the cap layer may be integrated with the forming the electrostatic discharge structure. Further, when an etching process needs to be performed to form the polysilicon structure of the electrostatic discharge structure in a desired shape, the etching process may be simultaneously used to flatten the upper surface of the polysilicon structure replacing the cap layer, and therefore, there is no need of an additional flattening process to flatten the upper surface of the polysilicon structure. In general, embodiments of the present disclosure reduce the complexity and cost of the semiconductor processes.

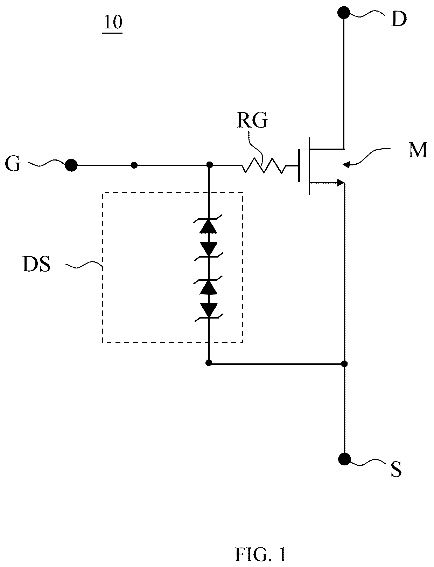

FIG. 1 is a circuit diagram of a semiconductor structure 10 according to embodiments of the present disclosure. The semiconductor structure 10 has a gate electrode G, a drain electrode D and a source electrode S, and includes a transistor M, a gate resistor RG and a diode string DS. The transistor M may be a semiconductor power device of different types or manufactured by different technologies. The source and drain of the transistor M are respectively connected to the source electrode S and the drain electrode D. The gate of the transistor M is coupled to the gate electrode G via the gate resistor RG. The diode string DS is coupled between the gate electrode G and the source electrode S, and the diode string DS includes a plurality of back-to-back diodes connected in series. The diode string DS serves as an electrostatic discharge protection structure of the semiconductor structure 10. As shown in FIG. 1 as an example, the diode string DS includes two groups of back-to-back diodes. It should be understood that embodiments of the present disclosure use two groups of back-to-back diodes for illustration convenience only, and the present disclosure is not limited thereto. The diode string DS may include various numbers of groups of back-to-back diodes, which are within the scope of the present disclosure.

In the embodiment of FIG. 1, the transistor M is an N-type transistor. However, the present disclosure is not limited thereto, e.g., in other embodiments, the transistor M may be a P-type transistor.

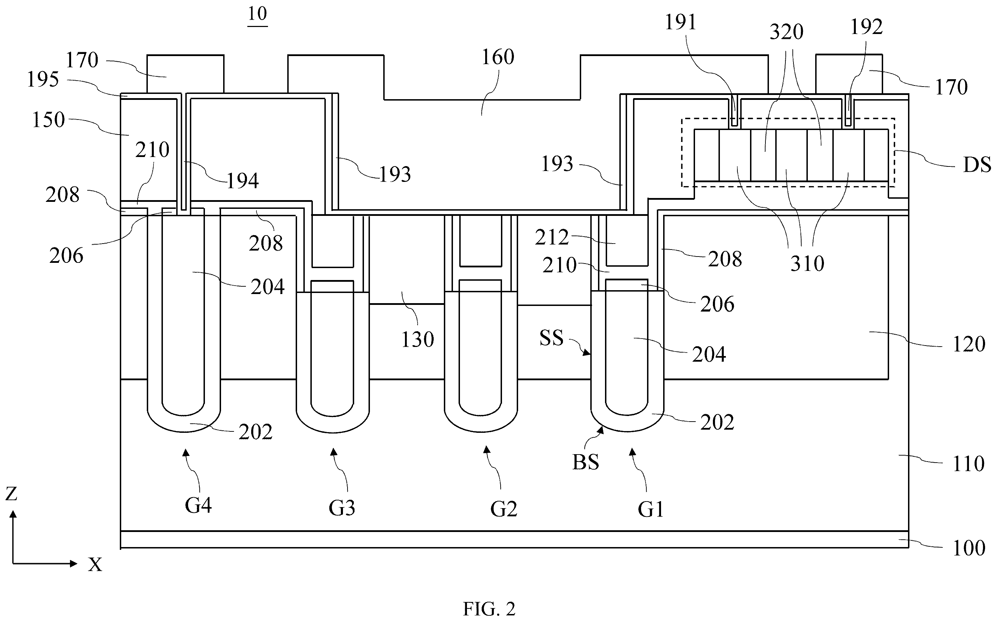

In some embodiments, the number of groups of back-to-back diodes in the diode string DS may be determined by the withstand voltage of the semiconductor structure 10, such as the breakdown voltage of a gate oxide layer 202 (shown in FIG. 2) of the transistor M. More specifically, when an electrostatic discharge event occurs, the gate resistor RG can prevent the instantaneous large current, which is caused by the electrostatic discharge event from the gate electrode G, from directly attacking the gate (e.g., the gate oxide layer 202) of the transistor M. The instantaneous large current can flow to the source electrode S through the diode string DS (i.e., the electrostatic discharge protection structure) so as to be transmitted away from the transistor M. In some embodiments, the source electrode S is coupled to a ground terminal, and the instantaneous large current caused by the electrostatic discharge event can flow to the ground terminal through the diode string DS.

In other words, when an electrostatic discharge event occurs, the gate resistor RG and the diode string DS can provide electrostatic discharge protection for the transistor M. However, for the diode string DS to work as designed for electrostatic discharge protection, it is necessary to achieve the condition that the withstand voltage of the diode string DS is less than the breakdown voltage of the gate oxide layer 202 of the transistor M. When the voltage caused by the instantaneous large current reaches the withstand voltage of the diode string DS first, the diode string DS is turned on and the instantaneous large current does not flow to the gate of the transistor M. Instead, the instantaneous large current is directed to flow through the diode string DS that is turned on. Thus, the withstand voltage of the diode string DS needs to be less than the breakdown voltage of the gate oxide layer 202 of the transistor M. Therefore, the number of groups of back-to-back diodes in the diode string DS is limited by the breakdown voltage of the gate oxide layer 202 of the transistor M.

FIG. 2 is a schematic diagram of the semiconductor structure 10 according to embodiments of the present disclosure. The semiconductor structure 10 includes a substrate 100, an epitaxial layer 110, an interlayer oxide layer 150, a source electrode 160, a gate electrode 170, a diode string DS, a gate structure G1, a gate structure G2, a gate structure G3, and a gate structure G4.

The semiconductor structures of embodiments of the present disclosure are described in a coordinate system including an X-direction, a Y-direction and a Z-direction perpendicular to each other. The Z-direction represents the vertical direction, i.e., in the top-bottom direction of the semiconductor structure 10. The Z-direction is perpendicular to a plane formed by the X-direction and the Y-direction. The X-direction is in the width direction of the semiconductor structure 10. The Y-direction is in the length direction of the semiconductor structure 10. The plane formed by the X-direction and the Y-direction is parallel to (or substantially parallel to) the top surface of the substrate 100. FIG. 2 is a cross-sectional view of the semiconductor structure 10 along a plane formed by the X-direction and the Z-direction.

The epitaxial layer 110 is disposed on the substrate 100. The diode string DS is disposed over the epitaxial layer 110. The source electrode 160 and the gate electrode 170 are disposed over the epitaxial layer 110 and the diode string DS. The interlayer oxide layer 150 is disposed on the epitaxial layer 110, surrounding the source electrode 160 and the diode string DS, and covering the diode string DS.

In some embodiments, the substrate 100 may be disposed on an upper surface of a substrate of an adjacent silicon wafer or other semiconductor materials. In some embodiments, the substrate 100 is a portion of a silicon wafer. The material of the substrate 100 may include a single crystal silicon material, an epitaxial silicon material, silicon carbide (SiC), germanium (Ge), silicon germanium (SiGe), gallium nitride (GaN), gallium arsenide (GaAs), gallium arsenide phosphide (GaAsP) or other semiconductor materials.

In some embodiments, the epitaxial layer 110 may include, for example, a single crystal silicon material, an epitaxial silicon material, silicon carbide (SiC), germanium (Ge), silicon germanium (SiGe), gallium nitride (GaN), gallium arsenide (GaAs), gallium arsenide phosphide (GaAsP) or other semiconductor materials that may be N-type (referred to as a first conductivity type) or P-type (referred to as a second conductivity type). In some embodiments, the substrate 100 and the epitaxial layer 110 are formed of N-type epitaxial materials. For illustration convenience, N-type will be used for the substrate 100 and the epitaxial layer 110 as an example in the following description, but the present disclosure is not limited thereto. Whether the substrate 100 and the epitaxial layer 110 are N-type or P-type may be determined/adjusted according to the electrical requirements of the semiconductor structure 10. In some embodiments, the doping concentration of the substrate 100 is greater than the doping concentration of the epitaxial layer 110.

In some embodiments, the epitaxial layer 110 may have a doped region. The doped region extends from the top of the epitaxial layer 110 toward the substrate 100, and the doped region includes a first lightly doped region 120 and a second lightly doped region 130. The doped region extends from the top surface of the epitaxial layer 110 toward the substrate 100 in the Z-direction, and extends into the epitaxial layer 110 without contacting the substrate 100. The second lightly doped region 130 is disposed in the first lightly doped region 120. The top surface of the first lightly doped region 120 and the top surface of the second lightly doped region 130 are substantially coplanar, and the bottom surface of the first lightly doped region 120 is closer to the substrate 100 than the bottom surface of the second lightly doped region 130. The top surface of the first lightly doped region 120 and the top surface of the second lightly doped region 130 are coplanar with the top surface of the epitaxial layer 110.

In some embodiments, the first lightly doped region 120 is of P-type (the second conductivity type), and the doping concentration of the first lightly doped region 120 is greater than the doping concentration of the epitaxial layer 110. In some embodiments, the first lightly doped region 120 serves as a doped body region of the transistor M. In some embodiments, the second lightly doped region 130 is of N-type (the first conductivity type). The doping concentration of the second lightly doped region 130 may substantially be greater than the doping concentration of the first lightly doped region 120. In some embodiments, the second lightly doped region 130 serves as a part of the source structure of the transistor M. For the sake of simplicity, FIG. 2 does not show the drain structure of the transistor M.

The gate structures G1, G2, G3 and G4 are spaced apart in the X-direction. The gate structure G2 may be disposed between the gate structure G1 and the gate structure G3. On the plane defined by the X-direction and the Z-direction, the gate structures G1, G2, G3 and G4 have trench profiles. A trench profile (or referred to as a trench) has sidewalls SS and a bottom surface BS. Specifically, the trench profile may have two opposing sidewalls SS (or side surfaces) and the bottom surface BS extending between the two opposing sidewalls SS. In some embodiments, the gate structures G1, G2, G3 and G4 have vertical sidewalls SS and an arc-shaped bottom surface BS. The gate structures G1, G2, G3 and G4 extend from the top surface of the epitaxial layer 110 toward the substrate 100 and into the epitaxial layer 110, and are at least partially surrounded by the doped region. The bottom surface BS of the gate structures G1, G2, G3 and G4 protrudes from the bottom surface of the first lightly doped region 120. The gate structures G1, G2, G3 and G4 extend from the top surface of the epitaxial layer 110 (or the top surface of the doped region), passing through the first lightly doped region 120 (the doped region), and into the epitaxial layer 110. The bottom surface BS of each of the gate structures G1, G2, G3 and G4 (i.e., the bottom surface BS of the trench) is closer to the substrate than the bottom surface of the first lightly doped region 120 (the doped region). In some embodiments, the gate structures G1, G2, G3 and G4 may have the same depth along the Z-direction. In some embodiments, the gate structures G1, G2, G3 and G4 serve as gate structures of the transistor M.

The gate structure G1, the gate structure G2 and the gate structure G3 include the gate oxide layer 202, a first polysilicon structure 204, a thermal oxide layer 206, a thermal oxide layer 208, an insulating layer 210 and a second polysilicon structure 212. The gate oxide layer 202 is conformally arranged in the trenches of the gate structures G1~G3 according to the trench profiles of the gate structures G1~G3 and surrounds the first polysilicon structure 204. The top surfaces of the gate oxide layer 202 and the first polysilicon structure 204 are coplanar. The insulating layer 210 is arranged over the first polysilicon structure 204 and the gate oxide layer 202. The insulating layer 210 of the gate structure G1 further extends between the doped region and the diode string DS. The insulating layer 210 of the gate structure G3 further extends between the doped region and the interlayer oxide layer 150. The second polysilicon structure 212 is arranged over the first polysilicon structure 204 and the insulating layer 210, and is surrounded by the insulating layer 210. The top surface of the second polysilicon structure 212, the top surface of the first lightly doped region 120 and the top surface of the second lightly doped region 130 are coplanar. The thermal oxide layer 206 is disposed on the first polysilicon structure 204. The thermal oxide layer 208 extends between the doped region and the insulating layer 210. The thermal oxide layer 208 of the gate structure G1 further extends between the doped region and the diode string DS. The thermal oxide layer 208 of the gate structure G3 extends between the doped region and the interlayer oxide layer 150.

As shown and described above, the gate structures G1~G3 have a similar configuration, which includes the gate oxide layer 202, the first polysilicon structure 204, the thermal oxide layer 206, the thermal oxide layer 208, the insulating layer 210 and the second polysilicon structure 212. In a trench of each of the gate structures G1~G3, the first polysilicon structure 204 and the gate oxide layer 202 surrounding the first polysilicon structure 204 occupy a first portion of the trench, covering the bottom surface BS and a portion of the sidewalls SS of the trench. The thermal oxide layer 206, the thermal oxide layer 208, the insulating layer 210 and the second polysilicon structure 212 are in a second portion of the trench which is over the first portion of the trench.

In some embodiments, the thermal oxide layer 206 may be aligned with the first polysilicon structure 204 in the Z-direction. The thermal oxide layer 206 may be aligned with the second polysilicon structure 212 in the Z-direction. The first polysilicon structure 204, the thermal oxide layer 206 and the second polysilicon structure 212 may be aligned with each other in the Z-direction. In some embodiments, the second polysilicon structure 212 may not be aligned with the first polysilicon structure 204 and the thermal oxide layer 206 in the Z-direction. For example, the second polysilicon structure 212 and the first polysilicon structure 204 may be staggered such that a portion of the first polysilicon structure 204 does not overlap with a portion of the second polysilicon structure 212 in the Z-direction.

The insulating layer 210 in the trench surrounds and separates the thermal oxide layer 206 and the second polysilicon structure 212. The insulating layer 210 in the trench separates the second polysilicon structure 212 from the first polysilicon structure 204 and the gate oxide layer 202. The thermal oxide layer 208 is disposed on the sidewalls SS of the second portion of the trench, and surrounds the insulating layer 210, the thermal oxide layer 206 and the second polysilicon structure 212. The insulating layer 210 in the trench includes a portion that is between the thermal oxide layer 206 and the thermal oxide layer 208, a portion that is between the thermal oxide layer 208 and the second polysilicon structure 212, and a portion that is between the thermal oxide layer 206 and the second polysilicon structure 212.

Specifically, the thermal oxide layer 208 of the gate structure G1 may be composed of three portions. A first portion is disposed on one sidewall SS of the trench of the gate structure G1 (or referred to as a first sidewall of the gate structure G1). A second portion is disposed on the other sidewall SS of the trench of the gate structure G1 (or referred to as a second sidewall of the gate structure G1 opposite to the first sidewall). A third portion extends out of the trench of the gate structure G1, and extends on the top surface of the epitaxial layer 110 (and the top surface of the doped region), covering a first portion of the epitaxial layer 110 (and a first portion of the doped region). The third portion of the thermal oxide layer 208 of the gate structure G1 is disposed between the diode string DS and the first portion of the epitaxial layer 110, and is connected to the second portion of the thermal oxide layer 208 of the gate structure G1.

In addition, the insulating layer 210 of the gate structure G1 further includes a portion that extends out of the trench of the gate structure G1 and over the top surface of the epitaxial layer, and specifically, extends between the third portion of the thermal oxide layer 208 of the gate structure G1 and the diode string DS. This portion of the insulating layer 210 of the gate structure G1 may further includes: a first sub-portion connected to the insulating layer 210 disposed in the trench of the gate structure G1, a second sub-portion below the diode string DS and connected to the first sub-portion, and a third sub-portion connected to second sub-portion. The first sub-portion and the third sub-portion do not overlap with the diode string DS in a top view of the semiconductor structure 10. The second sub-portion is between the first sub-portion and the third sub-portion in the X-direction. The thickness of the second sub-portion may be different from, e.g., greater than, the thickness of the first and/or second sub-portion.

The gate structure G3 may have a similar structure to the gate structure G1. Specifically, the thermal oxide layer 208 of the gate structure G3 may be composed of three portions. A first portion is disposed on one sidewall SS of the trench of the gate structure G3 (or referred to as a first sidewall of the gate structure G3). A second portion is disposed on the other sidewall SS of the trench of the gate structure G3 (or referred to as a second sidewall of the gate structure G3 opposite to the first sidewall). A third portion extends out of the trench of the gate structure G3, and extends on the top surface of the epitaxial layer 110 (and the top surface of the doped region), covering a second portion of the epitaxial layer 110 (and a second portion of the doped region). The third portion of the thermal oxide layer 208 of the gate structure G3 is located between the interlayer oxide layer 150 and the second portion of the epitaxial layer 110, and is connected to the second portion of the thermal oxide layer 208 of the gate structure G3.

In addition, the insulating layer 210 of the gate structure G3 further includes a portion that extends out of the trench of the gate structure G3, and extends between the third portion of the thermal oxide layer 208 of the gate structure G3 and the interlayer oxide layer 150. This portion of the insulating layer 210 of the gate structure G3 covers the third portion of the thermal oxide layer 208 of the gate structure G3 in the top view of the semiconductor structure 10.

The gate structure G4 includes the gate oxide layer 202, the first polysilicon structure 204, the thermal oxide layer 206, the thermal oxide layer 208 and the insulating layer 210. Similarly, the gate oxide layer 202 is conformally disposed in the trench of the gate structure G4 according to the trench profile of the gate structure G4, and surrounds the first polysilicon structure 204. The top surfaces of the gate oxide layer 202 and the first polysilicon structure 204 of the gate structure G4 are coplanar with the top surfaces of the first lightly doped region 120 and the second lightly doped region 130 (and the top surface of the doped region). The top surfaces of the gate oxide layer 202 and the first polysilicon structure 204 of the gate structure G4 are coplanar with the top surface of the epitaxial layer 110. The thermal oxide layer 206 is disposed on the first polysilicon structure 204. The thermal oxide layer 206 of the gate structure G4 may be aligned with the first polysilicon structure 204 of the gate structure G4 in the Z-direction. The thermal oxide layer 208 of the gate structure G4 is disposed between the doped region and the interlayer oxide layer 150, and a portion of the thermal oxide layer 208 is connected to the thermal oxide layer 208 of the gate structure G3 (e.g., the third portion of the thermal oxide layer 208 of the gate structure G3 extended on the top surface of the doped region). It should be noted that the thermal oxide layer 208 of the gate structure G4 is not disposed within the trench profile of the gate structure G4. The thermal oxide layer 206 of the gate structure G4 is out of the trench of the gate structure G4. In some embodiments, the gate structure G4 does not include the second polysilicon structure 212.

The thermal oxide layer 206 and the thermal oxide layer 208 of the gate structure G1, the gate structure G2, the gate structure G3 and the gate structure G4 may be formed simultaneously by a thermal oxidation process. Specifically, the thermal oxidation process converts a portion of silicon molecules in the first polysilicon structure 204 into silicon oxide molecules to form the thermal oxide layer 206 (also called a bottom portion), and converts a portion of silicon molecules in the doped region into silicon oxide molecules to form the thermal oxide layer 208 (also called a sidewall portion), where the thermal oxide layer 206 does not contact the thermal oxide layer 208. Although the thermal oxide layer 206 and the thermal oxide layer 208 are formed simultaneously, the thickness of the thermal oxide layer 206 on the first polysilicon structure 204 may be greater than the thickness of the thermal oxide layer 208 extending between the doped region and the insulating layer 210. In some embodiments, the thickness of the thermal oxide layer 208 may be less than the thickness of the gate oxide layer 202, and the top surface of the gate oxide layer 202 is not completely covered by the thermal oxide layer 208. That is, the top surfaces of the gate oxide layer 202 in the trenches of the gate structures G1~G3 is not completely covered by the thermal oxide layer 208 (disposed on the sidewalls of the trenches). As a result, when the insulating layer 210 is formed, the insulating layer 210 of the gate structures G1~G3 directly contacts the top surface of the gate oxide layer 202 of the gate structures G1~G3. The insulating layer 210 in each of the gate structures G1~G3 contacts a portion of the top surface of the gate oxide layer 202. The insulating layer 210 of the gate structure G4 contacts the top surface of the gate oxide layer 202 of the gate structure G4. In some embodiments, the thickness of the insulating layer 210 may be greater than the thickness of the thermal oxide layer 206, e.g., the thickness of a portion of the insulating layer 210 covering the gate oxide layer 202. In some embodiments, the thickness of the insulating layer 210 may be greater than the thickness of the oxide layer 208, e.g., the thickness of a portion of the insulating layer 210 extended over the top surface of the epitaxial layer 110, or the thickness of a portion of the insulating layer 210 between the second polysilicon structure 212 and the thermal oxide layer 208 disposed on the sidewall of the trench.

In some embodiments, the thermal oxide layer 206 and the thermal oxide layer 208 may be omitted. In this case , the insulating layer 210 is disposed on the gate oxide layer 202 and the first polysilicon structure 204, and directly contacts the gate oxide layer 202, the first polysilicon structure 204, the first lightly doped region 120, and the second lightly doped region 130.

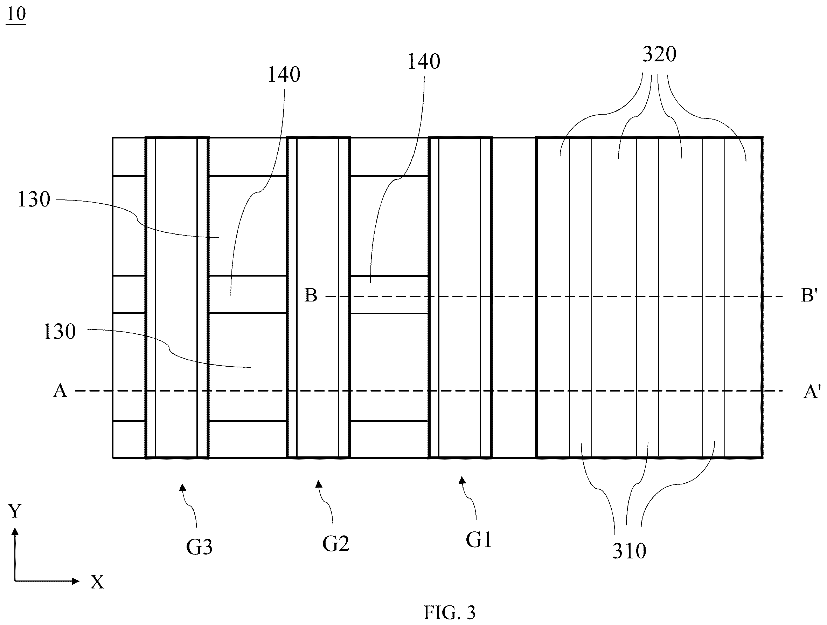

The second lightly doped region 130 is disposed between the gate structure G1 and the gate structure G2 and between the gate structure G2 and the gate structure G3. The bottom surface of the second lightly doped region 130 is closer to the substrate 100 than the top surface of the first polysilicon structure 204 of the gate structure G1, the gate structure G2 and the gate structure G3. The second lightly doped region 130 may include a plurality of sub-regions 130 spaced apart along the Y-direction in the first lightly doped region 120, which will be further described with respect to FIG. 3.

The number of gate structures G1, G2, G3 and G4 disclosed in embodiments of the present disclosure is only an example, and various numbers of the gate structures G1, G2, G3 and G4 are within the scope of the present disclosure. Specifically, the semiconductor structures of the embodiments of the present disclosure show one gate structure G1, one gate structure G2, one gate structure G3 and one gate structure G4 included merely as examples. Various numbers of the gate structure G1, various numbers of the gate structure G2, various numbers of the gate structure G3 and/or various numbers of the gate structure G4 may be possible. For example, in other embodiments, the semiconductor structure 10 includes more than one gate structure G2 between the gate structure G1 and the gate structure G3, and there gate structures G2 are arranged next to each other and spaced apart in the X-direction.

The diode string DS is disposed on the insulating layer 210. In the Z-direction, the diode string DS does not overlap with the gate structure G1, the gate structure G2, the gate structure G3, and the gate structure G4. The diode string DS includes a plurality of first doped regions 310 having a first conductivity type and a plurality of second doped regions 320 having a second conductivity type. The plurality of first doped regions 310 and the plurality of second doped regions 320 are alternately disposed, and the interface between any two adjacent regions 310 and 320 forms a PN junction.

The interlayer oxide layer 150 is disposed on the insulating layer 210, and on the second polysilicon structure 212 of the gate structure G1 and the second polysilicon structure 212 of the gate structure G3. The interlayer oxide layer 150 may directly contact the second polysilicon structure 212 of the gate structure G1 and the second polysilicon structure 212 of the gate structure G3. In some embodiments, the interlayer oxide layer 150 is used to define the region of the source electrode 160 and the gate electrode 170. Specifically, the portion not covered/occupied by the interlayer oxide layer 150 can be used to form the source electrode 160 or the gate electrode 170. It should be understood that the position and shape of the interlayer oxide layer 150 as shown are only for illustration, and the present disclosure is not limited thereto. In some embodiments, the interlayer oxide layer 150 may have other suitable shapes and suitable distributions different than what is shown.

The source electrode 160 adjoins the second lightly doped region 130 in the doped region of the epitaxial layer 110, the second polysilicon structure 212 of the gate structure G1, the second polysilicon structure 212 of the gate structure G2, and the second polysilicon structure 212 of the gate structure G3. The source electrode 160 may cover a portion of the interlayer oxide layer 150.

The gate electrode 170 is disposed on the interlayer oxide layer 150, and corresponds to the gate structure G4 and the diode string DS in the Z-direction.

The semiconductor structure 10 may further include a conductive plug 191, a conductive plug 192, a metal layer 193 and a conductive plug 194. The source electrode 160 is electrically coupled to the diode string DS through the conductive plug 191. The gate electrode 170 is electrically coupled to the diode string DS and the gate structure G4 through the conductive plug 192 and the conductive plug 194, respectively. Specifically, the conductive plug 191 adjoins a first end of the plurality of first doped regions 310 (as shown in FIG. 2, the leftmost one region 310 of the plurality of first doped regions 310). The conductive plug 192 adjoins a second end of the plurality of first doped regions 310 (as shown in FIG. 2, the rightmost one region 310 of the plurality of first doped regions 310). The conductive plug 194 adjoins the first polysilicon structure 204 of the gate structure G4. Although not shown in the present disclosure, the conductive plug 194 is electrically coupled to the first polysilicon structure 204 of the gate structure G1, the gate structure G2 and the gate structure G3.

The metal layer 193 is disposed between the source electrode 160 and the interlayer oxide layer 150. More specifically, the metal layer 193 is disposed between the sidewalls extending in the Z-direction and between the source electrode 160 and the interlayer oxide layer 150. In some embodiments, the material of the metal layer 193 is the same as that of the conductive plug 191, the conductive plug 192, and the conductive plug 194.

In some embodiments, the semiconductor structure 10 may further include a barrier metal layer 195. The barrier metal layer 195 surrounds the source electrode 160, the metal layer 193, the conductive plug 191, the conductive plug 192 and the conductive plug 194, and adjoins the second lightly doped region 130, the gate structure G1, the gate structure G2, the gate structure G3 and the diode string DS. Specifically, the barrier metal layer 195 may adjoin the second polysilicon structure 212, the insulating layer 210 and the thermal oxide layer 208 of the gate structure G1, the gate structure G2 and the gate structure G3. The barrier metal layer 195 adjoins the first end and the second end of the plurality of first doped regions 310 of the diode string DS.

In some embodiments, the material of the barrier metal layer 195 may include cobalt (Co), nickel (Ni), titanium (Ti), or platinum (Pt). In some embodiments, the barrier metal layer 195 may be omitted.

FIG. 3 is a top view of the semiconductor structure 10 according to embodiments of the present disclosure. The top view of FIG. 3 illustrates a plane defined by the X-direction and the Y-direction. For ease of understanding, some components are omitted in the top view of FIG. 3. For example, the gate structure G4, the interlayer oxide layer 150, the source electrode 160, the gate electrode 170, the conductive plug 191, the conductive plug 192, the conductive plug 194, the metal layer 193, and the barrier metal layer 195 are omitted. In this example top view of FIG. 3, components above the top surface of the epitaxial layer 110 are removed for illustration purposes.

Referring to FIG. 3, the semiconductor structure 10 further includes a heavily doped region 140. The gate structures G1~G3 extend along the Y-direction and are surrounded by the second lightly doped region 130 and the heavily doped region 140. The second lightly doped region 130 and the heavily doped region 140 are adjacent to each other and alternately arranged in the Y-direction. In other words, the heavily doped region 140 and the second lightly doped region 130 surround each other. It should be noted that the second lightly doped region 130 and the heavily doped region 140 do not overlap in the top view.

The second lightly doped region 130 may include multiple sub-regions 130, each of which extends in the X-direction, has a width in the Y-direction and a thickness in the Z-direction. The sub-regions 130 may have the same width and thickness. The heavily doped layer 140 may include multiple sub-regions 140, each of which extends in the X-direction, has a width in the Y-direction and a thickness in the Z-direction. The sub-regions 140 may have the same width and thickness. The sub-regions 130 and the sub-regions 140 may be disposed alternately along the Y-direction, and do not overlap. A sub-region 130 is disposed between and adjoins two adjacent sub-regions 140. It may also be understood as that a sub-region 130 is surrounded by the adjacent sub-regions 140. A sub-region 140 is disposed between and adjoins two adjacent sub-regions 130. It may also be understood as that a sub-region 140 is surrounded by sub-regions 130. The sub-regions 130 may be parallel to the sub-regions 140.

The first doped regions 310 and the second doped regions 320 extend along the Y-direction and are disposed in parallel with the gate structures G1~G3. The diode string DS formed by the first doped regions 310 and the second doped regions 320 does not overlap with the gate structures G1~G3 in the top view.

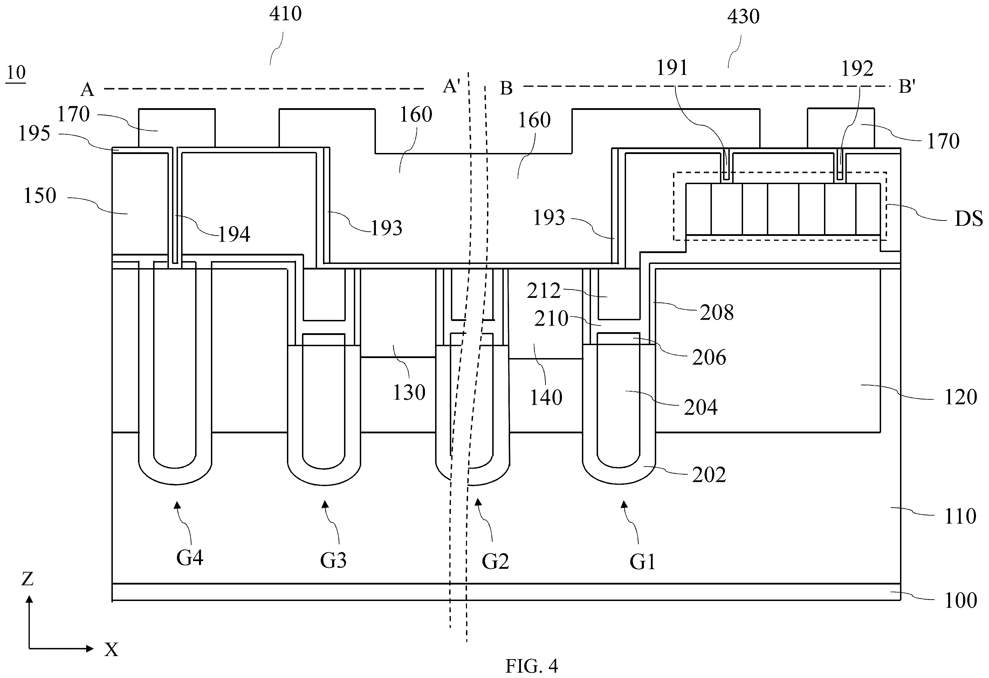

FIG. 4 is a side view of the semiconductor structure 10 according to embodiments of the present disclosure. The side view of FIG. 4 illustrates a plane defined by the X-direction and the Z-direction. The side view of FIG. 4 is divided into two parts, where the left side and the right side of the side view are separated by hyperbolic dashed lines, respectively representing the cross-sectional structures of a line segment AA ' (including the second lightly doped region 130) and a line segment BB' (including the heavily doped region 140) in FIG. 3.

Specifically, FIG. 4 shows a portion 410 and a portion 430 of the semiconductor structure 10 separated by the dashed hyperbolic lines. The portion 410 may be understood as a cross-sectional view of the semiconductor structure 10 in FIG. 2 along the line segment AA' shown in FIG. 3. The portion 430 may be understood as a cross-sectional view of the semiconductor structure 10 in FIG. 2 along the line segment BB' shown in FIG. 3. The portions 410 and 430 are shown side by side in FIG. 4 merely for illustration convenience. The heavily doped region 140 is shown in the portion 430, and the second lightly doped region 130 is shown in the portion 410. Figures from FIG. 4 to FIG. 27 are cross-sectional views showing the two portions 410 and 430, and will be described with respect to the two portions 410 and 430.

The heavily doped region 140 is disposed on the first lightly doped region 120. In some embodiments, the bottom surface of the heavily doped region 140 is coplanar with the bottom surface of the second lightly doped region 130. In some embodiments, the bottom surface of the heavily doped region 140 may be closer to the substrate 100 than the bottom surface of the second lightly doped region 130. The source electrode 160 adjoins both the second lightly doped region 130 and the heavily doped region 140. The second lightly doped region 130, the heavily doped region 140 and the source electrode 160 together serve as the source structure of the transistor M.

In some embodiments, the heavily doped region 140 is disposed in the first lightly doped region 120. The top surface of the heavily doped region 140 may be coplanar with the top surface of the first lightly doped region 120, the top surface of the second lightly doped region 130, and the top surface of the epitaxial layer 110.

The heavily doped region 140 is of P-type. In some embodiments, the doping concentration of the second lightly doped region 130 is less than the doping concentration of the heavily doped region 140 and greater than the doping concentration of the first lightly doped region 120.

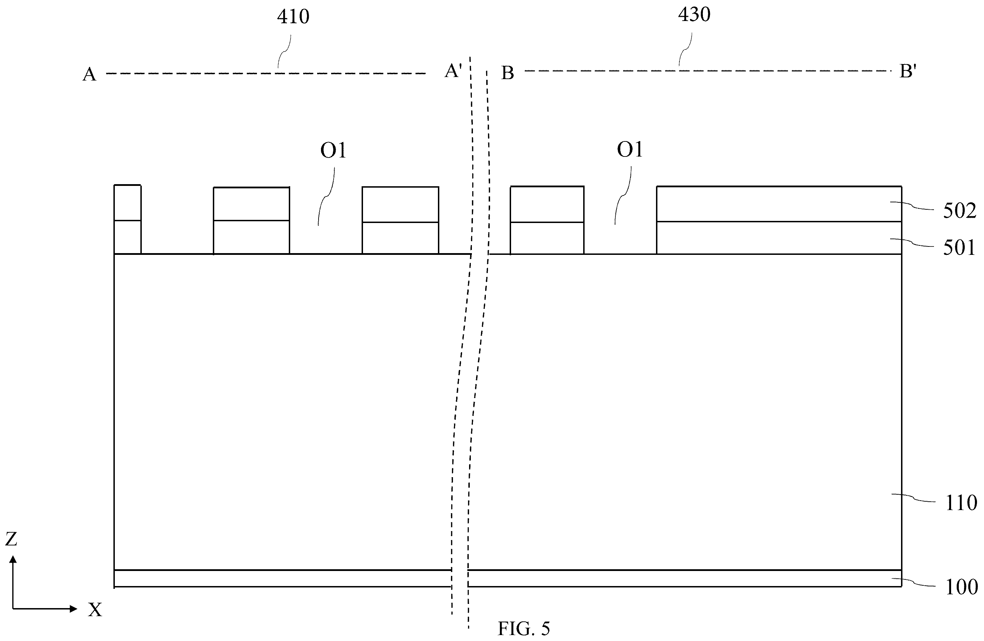

FIG. 5 to FIG. 24 are schematic diagrams of a manufacturing process of the semiconductor structure 10 according to embodiments of the present disclosure. For ease of understanding, FIG. 5 to FIG. 24 are divided into two parts, where the left side and right side are separated by hyperbolic dashed lines, respectively representing the manufacturing process of the cross-sectional structures of the line segment AA' and the line segment BB' in FIG. 3.

Specifically, FIG. 5 to FIG. 19 are cross-sectional views showing the portions 410 and 430 of the semiconductor structure 10 in various stages of the manufacture process for manufacturing the semiconductor structure 10. The semiconductor structure 10 may be similar to that as described above with respect to FIG. 2 to FIG. 4.

Refer to FIG. 5. The epitaxial layer 110 is formed on the substrate 100. An oxide hard mask 501 may be formed on the epitaxial layer 110 using a thermal oxidation process, and a patterned photoresist layer 502 may be formed on the oxide hard mask 501. The oxide hard mask 501 may be etched according to the patterned photoresist layer 502 to transfer the pattern on the photoresist layer 502 to the oxide hard mask 501. As shown in FIG. 5, after the pattern on the photoresist layer 502 is transferred to the oxide hard mask 501, a plurality of openings O1 are formed in the oxide hard mask 501. In some embodiments, after the pattern on the photoresist layer 502 is transferred to the oxide hard mask 501, the photoresist layer 502 is removed. The oxide hard mask 501 thus includes the openings O1 exposing a first portion of the epitaxial layer 110.

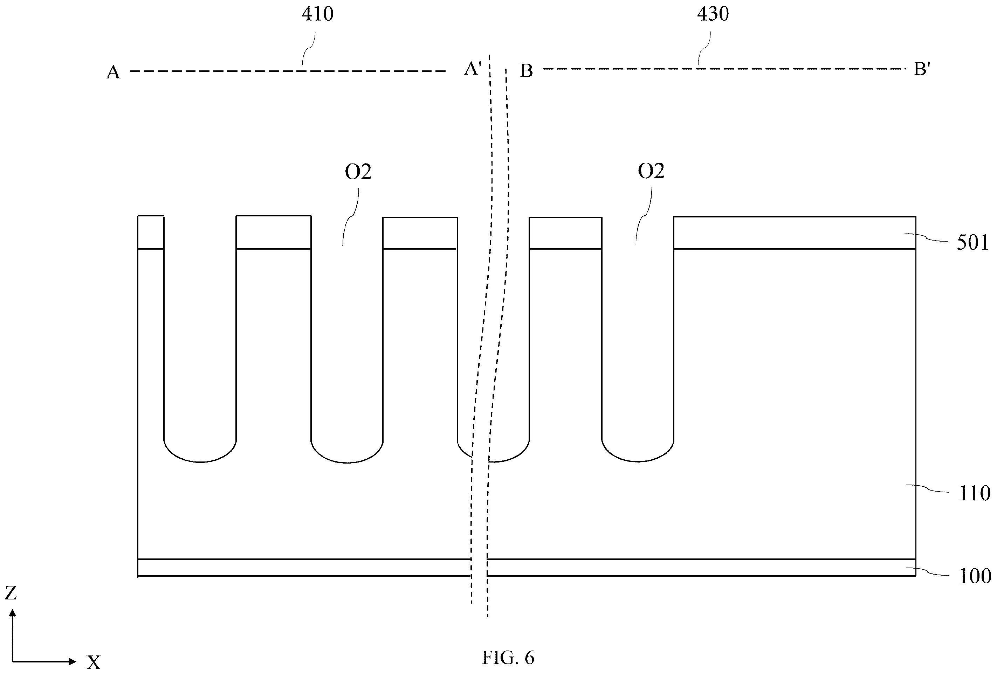

Refer to FIG. 6. A plurality of openings O2 extending toward the substrate 100 are formed in the epitaxial layer 110 corresponding to the openings O1 of the oxide hard mask 501. After the plurality of openings O2 are formed, the oxide hard mask 501 is removed.

The openings O2 may also be referred to as trenches, which will be used for forming the gate structures G1~G4. Each opening O2 is formed according to a corresponding O1, and is recessed from the top surface of the exposed first portion of the epitaxial layer 110 into the epitaxial layer 110, without touching the substrate 100. Each opening O2 has opposing sidewalls (or side surfaces) SS and a bottom surface BS extending between the opposing sidewalls SS. The sidewalls and the bottom surface of an opening may be collectively referred to as an inner side surface, or an inner surface, or surface of the opening in the present disclosure. After the oxide hard mask 501 is removed, the top surface of a second portion of the epitaxial layer 110 is exposed.

In some embodiments, after the oxide hard mask 501 is removed, a sacrificial oxide layer may be formed on the exposed surface of the epitaxial layer 110 by an oxidation process, and then the sacrificial oxide layer is removed. The exposed surface of the epitaxial layer 110 may include the top surface of the second portion of the epitaxial layer 110 that is exposed. The oxidation process may be performed by adding oxygen and heating to form oxide, such as silicon dioxide, on the surface of the epitaxial layer 110. In some embodiments, the formation and removal of the sacrificial oxide layer is to optimize the exposed surface of the epitaxial layer 110.

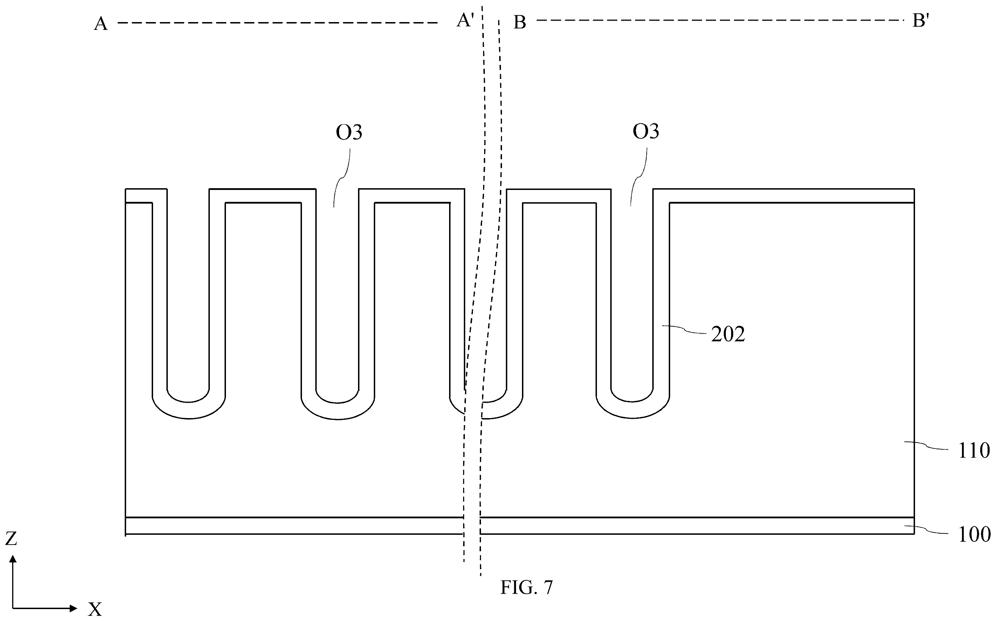

Refer to FIG. 7. The gate oxide layer 202 is formed on the surface of the epitaxial layer 110. The surface of the epitaxial layer 110 includes the exposed top surface of the second portion of the epitaxial layer 110. The gate oxide layer 202 is also formed on the inner surfaces of the openings O2, such that the openings O2 are reduced to become corresponding openings O3. In some embodiments, the thickness of the gate oxide layer 202 is substantially uniform. The gate oxide layer 202 may be formed on the exposed top surface of the second portion of the epitaxial layer 110 and on the inner surfaces of the openings O2, with a substantially uniform thickness. The gate oxide layer 202 formed on the exposed top surface of the second portion of the epitaxial layer 110 has a top surface covering the second portion of the epitaxial layer 110.

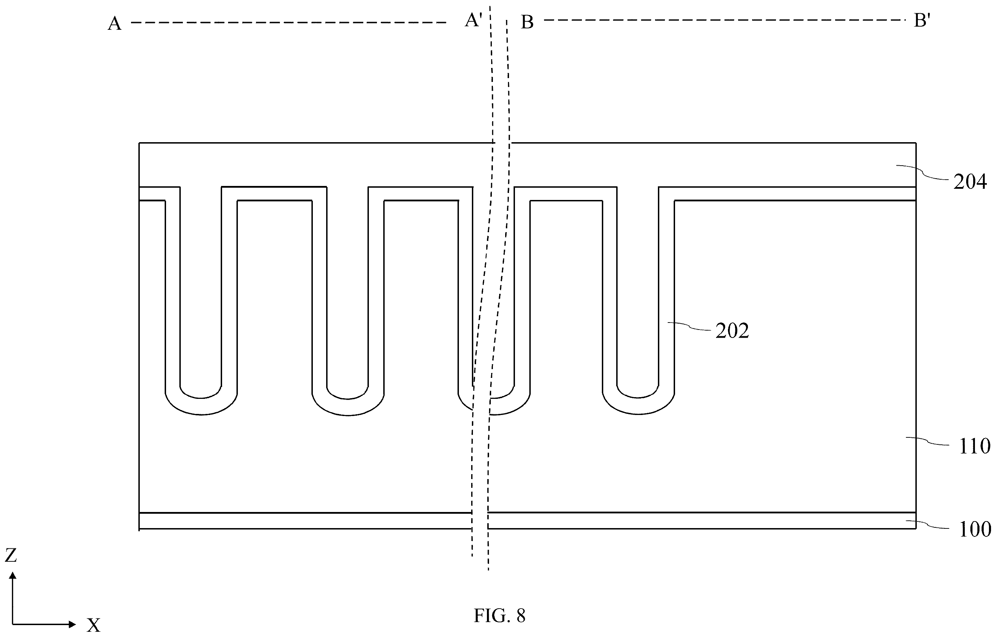

Refer to FIG. 8. The first polysilicon structure 204 is formed on the gate oxide layer 202 and fills the openings O3. The first polysilicon structure 204 may completely fill the openings O3, and cover the openings O3 and the second portion of the epitaxial layer 110.

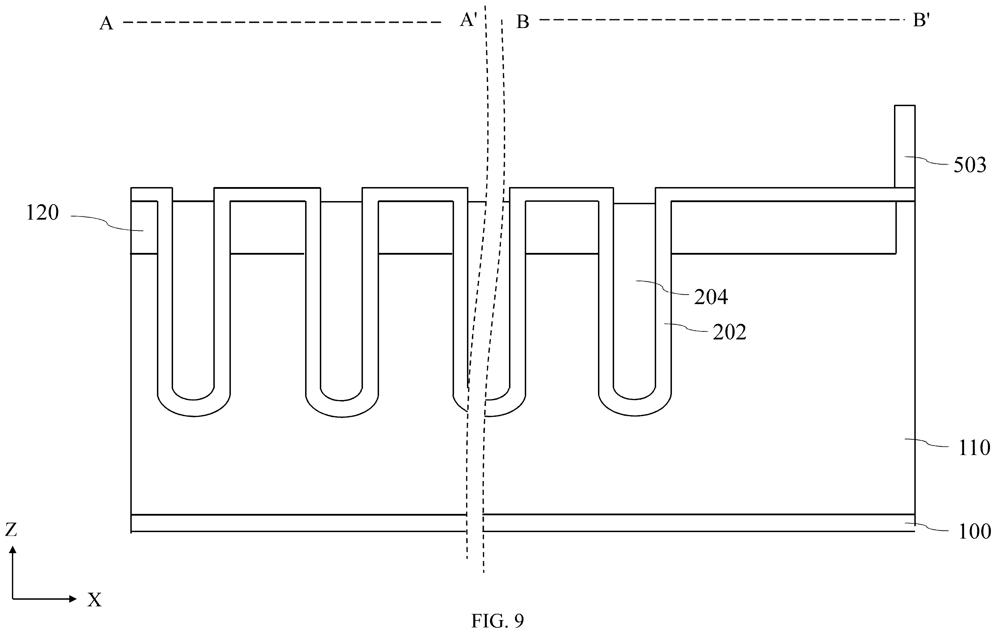

Refer to FIG. 9. An etching process may be performed to remove a portion of the first polysilicon structure 204. After the etching process, the top surface of the remaining first polysilicon structure 204 is lower than the top surface of the gate oxide layer 202. Specifically, the first polysilicon structure 204 disposed above the top surface of the gate oxide layer 202 is removed, and the first polysilicon structure 204 in the openings O3 is partially removed, leaving the remaining first polysilicon structure 204 in the openings O3. The top surface of the remaining first polysilicon structure 204 in the openings O3 may be coplanar with the top surface of the epitaxial layer 110.

A patterned photoresist layer 503 may be formed on the gate oxide layer 202, and an ion implantation process is performed based on the patterned photoresist layer 503 to form the first lightly doped region 120 in the epitaxial layer 110. The photoresist layer 503 defines a region in the epitaxial layer 110 where the first lightly doped region 120 is formed. The first lightly doped region 120 extends from the top surface of the epitaxial layer 110 toward the substrate 100. The bottom surface of the first lightly doped region 120 is higher than the bottom surfaces of the openings O3 (or the bottom surface of the first polysilicon structure 204 in the openings O3), i.e., the bottom surface of the first lightly doped region 120 is farther away from the substrate 100 than the bottom surfaces of the openings O3. The top surface of the first lightly doped region 120 is coplanar with the top surface of the epitaxial layer 110.

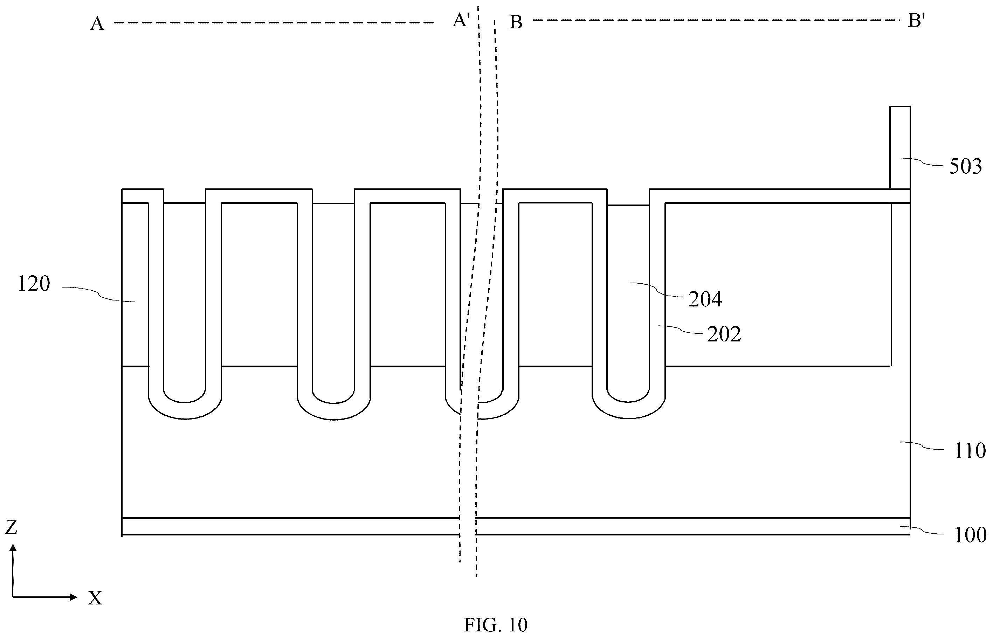

Refer to FIG. 10. A drive-in process may be performed to push the bottom surface of the first lightly doped region 120 closer to the substrate 100. The bottom surface of the first lightly doped region 120 is pushed down toward the substrate 100. After the drive-in process, the bottom surface of the first lightly doped region 120 is higher than the bottom surface of the gate oxide layer 202 in the Z-direction. That is, the bottom surface of the first lightly doped region 120 after the drive-in process is higher than the bottom surfaces of the openings O2 (shown in FIG. 6). After the drive-in process is performed, the photoresist layer 503 is removed. The use of the photoresist layer 503 results in a portion of the epitaxial layer 110 not covered by the first lightly doped region 120 in the Z-direction.

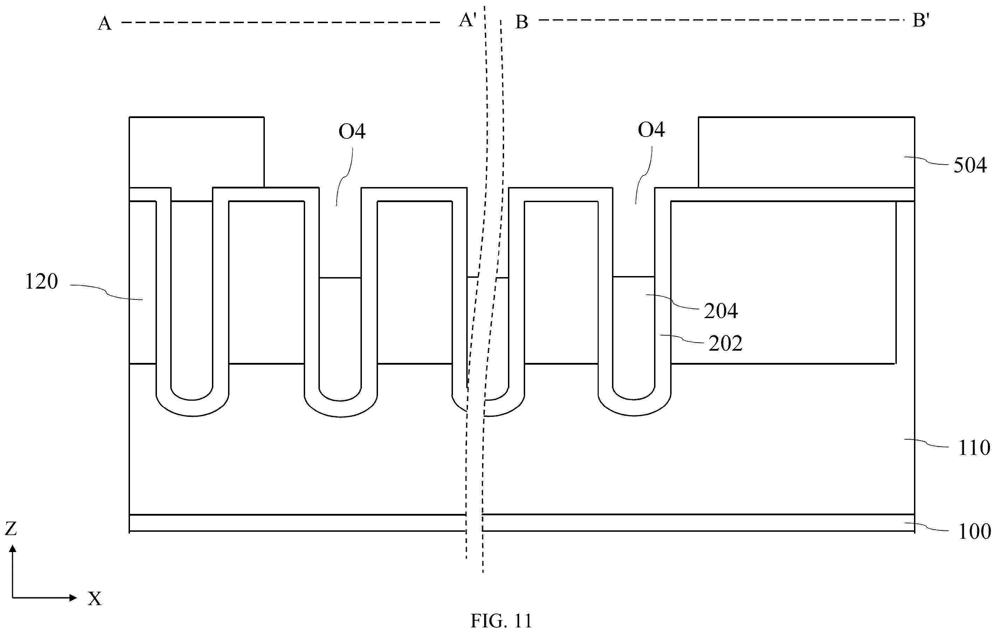

Refer to FIG. 11. A photoresist layer 504 is formed, and an etching process is performed according to the photoresist layer 504 to remove a portion of the first polysilicon structure 204. After the etching process, the top surface of the first polysilicon structure 204 is lower than the top surface of the first lightly doped region 120, thereby forming a plurality of openings O4 at the same time. After the etching process, the photoresist layer 504 is removed.

The photoresist layer 504 may be formed on the top surface of the gate oxide layer 202, covering a portion of the first lightly doped region 120, and also covering one opening O2, e.g., the leftmost opening O2 as shown as an example, in which the gate oxide layer 202 and the first polysilicon structure 204 surrounded by the gate oxide layer 202 are located. The opening O2 covered by the photoresist layer 504 is referred to as a "first opening O2" thereafter for illustration convenience. The gate oxide layer 202 and the first polysilicon structure 204 in the first opening O2 are referred to thereafter as a "first gate oxide layer 202" and a "covered first polysilicon structure 204," respectively, merely for illustration convenience. The first opening O2 corresponds to the gate structure G4 as described above with respect to FIG. 2.

The remaining first polysilicon structure 204 (from FIG. 9) in the openings O2 not covered by the photoresist layer 504 is partially removed through the etching process, exposing portions of the sidewalls of the corresponding openings O3, and resulting in the corresponding openings O4. With these openings O4 formed, the first polysilicon structure 204 in the openings O3 now has a top surface that is lower than the top surface of the first lightly doped region 120 and higher than the bottom surface of the first lightly doped region 120.

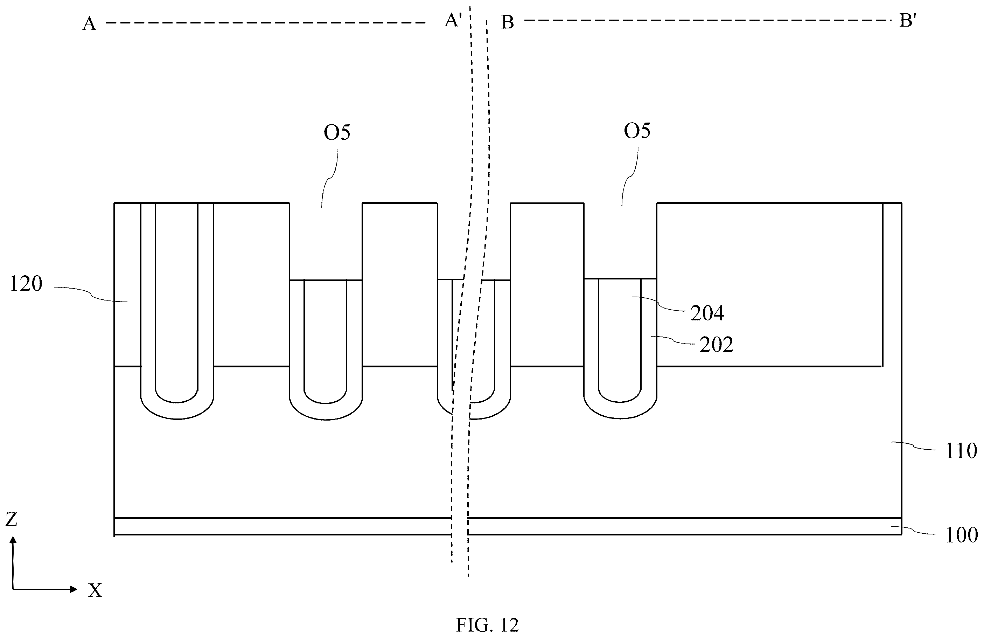

Refer to FIG. 12. An etching process is performed and a portion of the gate oxide layer 202 is removed. Specifically, the gate oxide layer 202 on the top surface of the first lightly doped region 120 is removed, and the gate oxide layer 202 in the openings O4, which is above the top surface of the first polysilicon structure 204, is removed. In addition, the gate oxide layer 202 on the top surface of the epitaxial layer 110 is also removed. Since the gate oxide layer 202 in the openings O4 is removed, the openings O4 are enlarged to become openings O5.

As a result, the gate oxide layer 202 remained in the openings O2 (shown in FIG. 6), where the openings O5 are located, has a top surface that is coplanar with the top surface of the first polysilicon structure 204 in those openings O2, and is lower than the top surface of the first lightly doped region 120 and higher than the bottom surface of the first lightly doped region 120.

After the etching process, the first gate oxide layer 202 and the covered first polysilicon structure 204 in the first opening O2 that has been covered by the photoresist layer 504 (the leftmost O2 as shown in FIG. 11) are exposed, and their respective top surfaces are coplanar with the top surface of the epitaxial layer 110 and the top surface of the first lightly doped region 120. In addition, the top surface of the first lightly doped region 120 is also exposed after the etching process is performed.

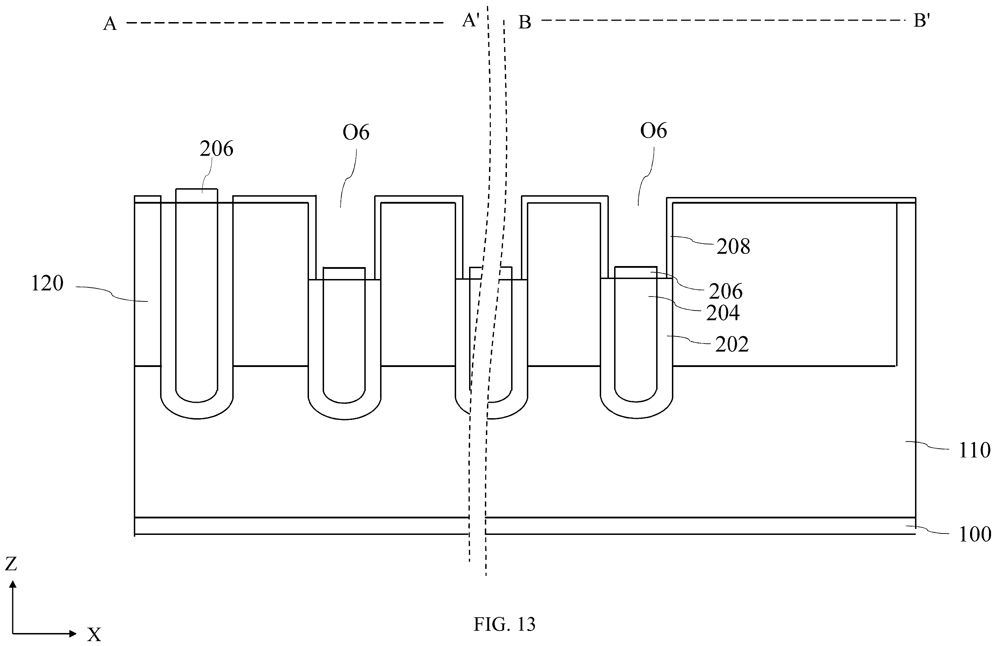

Refer to FIG. 13. A thermal oxidation process is performed to form the thermal oxide layer 206 and the thermal oxide layer 208. The thermal oxide layer 206 is formed on the exposed top surface of the first polysilicon structure 204. The thermal oxide layer 208 is formed on the exposed surface of the first lightly doped region 120. In some embodiments, the thermal oxide layer 206 may have a substantially uniform thicknesses. The thermal oxide layer 208 may have a substantially uniform thicknesses. The thickness of the thermal oxide layer 206 may be greater than the thickness of the thermal oxide layer 208. The thermal oxide layer 206 does not abut the gate oxide layer 202. The thermal oxide layer 208 in the openings O5 abuts the top surface of the gate oxide layer 202, but the thermal oxide layer 208 only covers a portion of the top surface of the gate oxide layer 202. The openings O5 are reduced to become openings O6 due to the formation of the thermal oxide layer 206 and the thermal oxide layer 208.

The thermal oxide layer 206 is formed on the exposed top surface of the covered first polysilicon structure 204 in the first opening O2 (the leftmost O2) and on the first polysilicon structure 204 in other openings O2. In some embodiments, the thermal oxide layer 206 does not adjoin the gate oxide layer 202.

The thermal oxide layer 206 formed on the top surface of the covered first polysilicon structure 204 in the first opening O2 extends above the top surface of the covered first polysilicon structure 204 and out of the first opening O2. The top surface of the thermal oxide layer 206 corresponding to the first opening O2 may be higher than the top surface of the thermal oxide layer 208 formed on the first lightly doped region 120. In some embodiments, no thermal oxide layer 208 is formed in the first opening O2. The top surface of the gate oxide layer 202 in the first opening O2 is exposed.

The thermal oxide layer 206 formed on the top surface of the first polysilicon structure 204 in other openings O2 extends above the top surface of the first polysilicon structure 204 and within the openings O5. The top surface of the thermal oxide layer 206 on the first polysilicon structure 204 is higher than the top surface of the first lightly doped region 120, and the top surface of the thermal oxide layer 206 in the openings O5 is lower than the top surface of the first lightly doped region 120.

The thermal oxide layer 208 is formed on the top surface of the first lightly doped region 120, the top surface of the epitaxial layer 110, and on the sidewalls of the openings O5. The thermal oxide layer 208 formed on the sidewalls of the openings O5 is in contact with and covering a portion of the top surface of the gate oxide layer 202 in openings O2 of the corresponding openings O5, with the remaining portion of the top surface of the gate oxide layer 202 exposed.

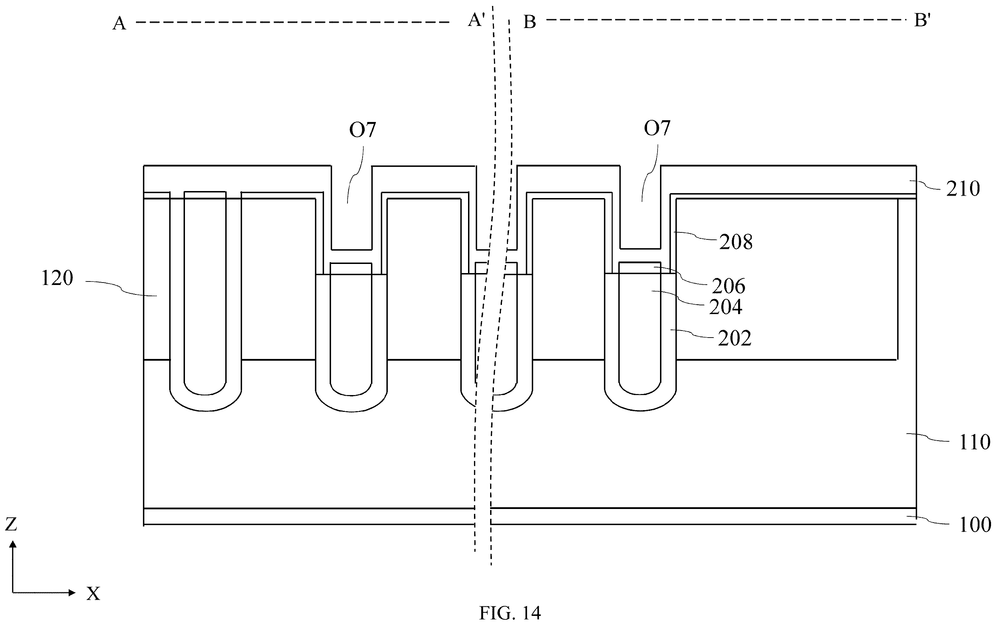

Refer to FIG. 14. A deposition process is performed to form the insulating layer 210. The insulating layer 210 is conformally formed on the structure shown in FIG. 13. In the openings O6, since the top surface of the gate oxide layer 202 is partially exposed, the insulating layer 210 directly contacts the gate oxide layer 202 and covers the thermal oxide layer 206. Near the thermal oxide layer 206, the insulating layer 210 may form a cross-sectional profile such as an "H" shape. After the insulating layer 210 is formed, the openings O6 are reduced to become openings O7. In some embodiments, the thickness of the insulating layer 210 on the top surface of the first lightly doped region 120 is greater than the thickness of the insulating layer 210 in the openings O7. In some embodiments, the insulating layer 210, the thermal oxide layer 206, and the thermal oxide layer 208 are silicon oxide. However, since the insulating layer 210 is formed in a different manner from the thermal oxide layer 206 and the thermal oxide layer 208, the quality of the insulating layer 210 is different from that of the thermal oxide layer 206 and the thermal oxide layer 208.

The insulating layer 210 may be formed to cover the exposed surface of the gate oxide layer 202, the thermal oxide layer 206, and the thermal oxide layer 208 (on the sidewalls of the openings O6, and the top surfaces of the first lightly doped region 120 and the epitaxial layer 110). The insulating layer 210 is formed in the openings O6, covering and in contact with the thermal oxide layer 208 disposed on the sidewalls of the openings O5, the thermal oxide layer 206 in the openings O5, and the partially exposed top surface of the gate oxide layer 202. The thermal oxide layer 208 disposed on the sidewalls of the openings O5 may have a thickness less than that disposed over the epitaxial layer 110. The insulating layer 210 in the openings O6 and over the epitaxial layer 110 is formed in a manner such that openings O7 are formed corresponding to the openings O6. The top surface of the insulating layer 210 in the openings O6 is lower than the top surface of the doped region and the top surface of the epitaxial layer 110.

In some embodiments, the semiconductor structure 10 may include the insulating layer 210 without including the thermal oxide layer 206 and the thermal oxide layer 208. In this case the manufacturing steps described with respect to FIG. 13 are omitted, and the positions/space occupied by the thermal oxide layer 206 and the thermal oxide layer 208 in FIG. 13 are replaced by the insulating layer 210. For example, the insulating layer 210 may be conformally formed on and covering the structure shown in FIG. 12. The insulating layer 210 is disposed on the gate oxide layer 202 and the first polysilicon structure 204 in the openings O5 and on the sidewalls of the openings O5.

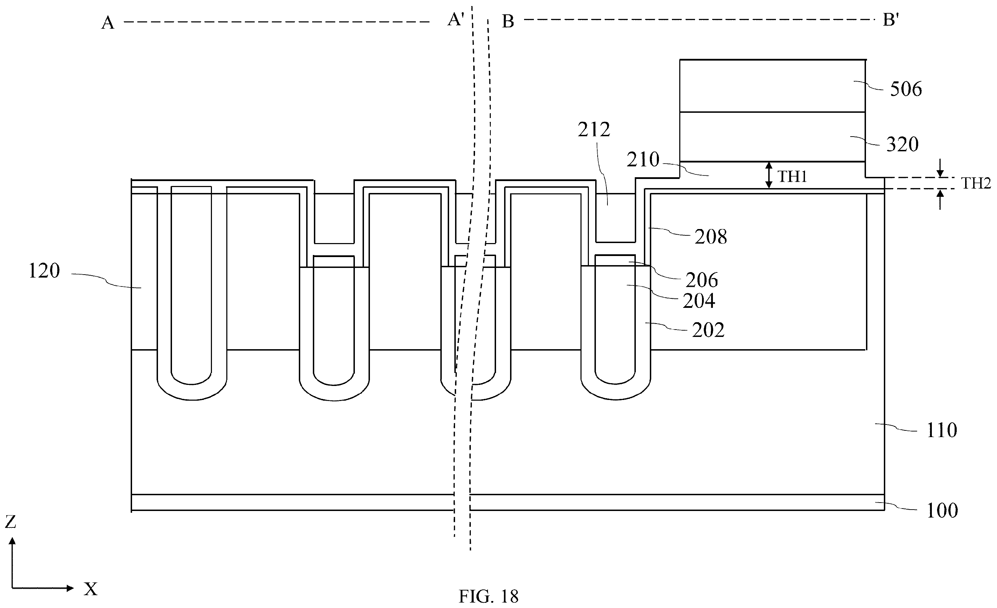

In other embodiments, the semiconductor structure 10 may include the thermal oxide layer 206 and the thermal oxide layer 208 without including the insulating layer 210, and in this case, the manufacturing steps described with respect to FIG. 14 are omitted. For example, the positions/ space occupied by the insulating layer 210 in the openings O6 may be replaced by the second polysilicon structure 212 (referring to FIG. 18).

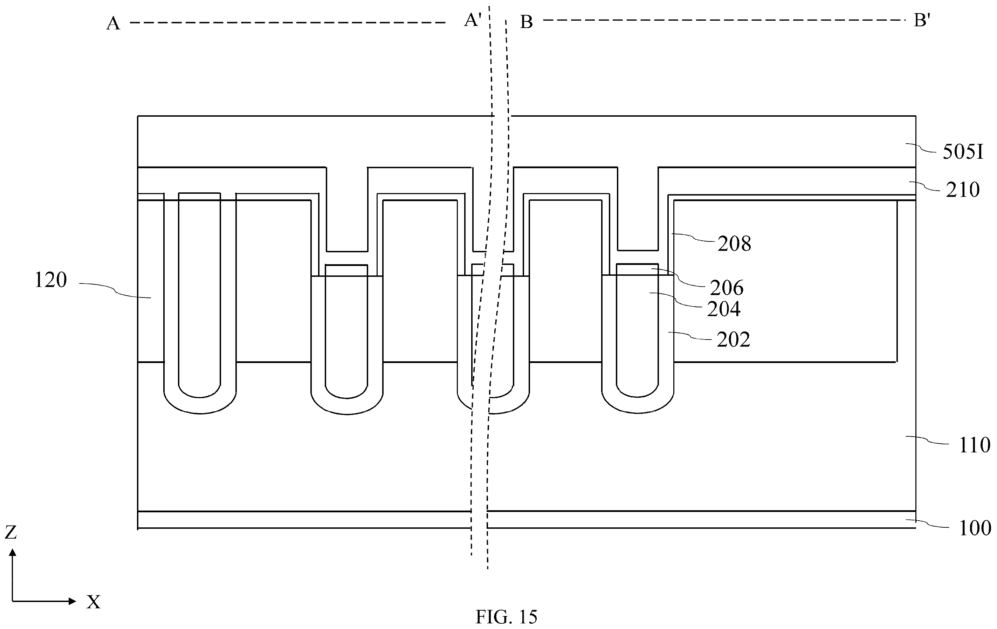

Refer to FIG. 15. A deposition process is performed to form a polysilicon layer 505I in the openings O7 and on the insulating layer 210. The polysilicon layer 505I is undoped polysilicon. The polysilicon layer 505I is completely filled in the openings O7 and covering the insulating layer 210 (in the openings O6 and on the doped region/the epitaxial layer 110).

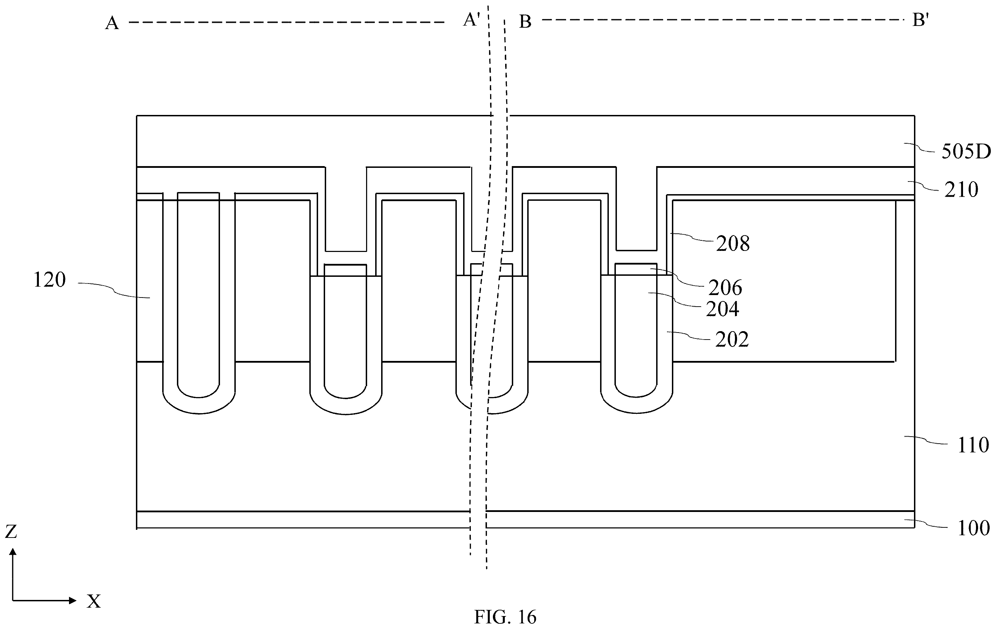

Refer to FIG. 16. An ion implantation process is performed on the polysilicon layer 505I to convert the undoped polysilicon layer 505I into a P-type polysilicon layer 505D. In some embodiments, after the ion implantation process is performed, an annealing process may be performed on the polysilicon layer 505D. In some embodiments, the polysilicon layer 505D may be of N-type.

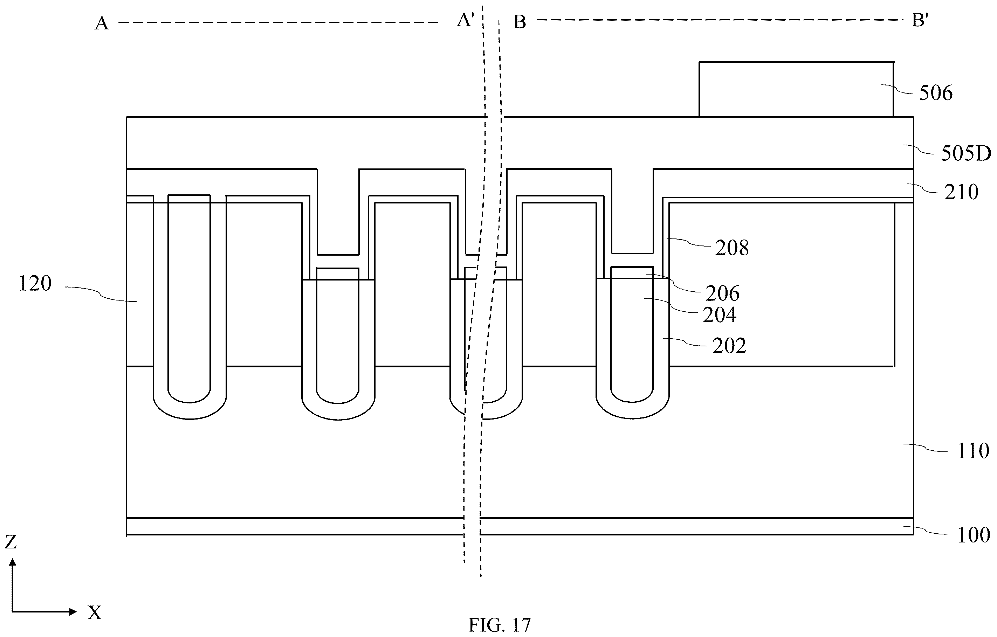

Refer to FIG. 17. A photoresist layer 506 is formed on the polysilicon layer 505D. The photoresist layer 506 is used to define the position of the diode string DS. In some embodiments, a side of the photoresist layer 506 away from the openings in the X-direction may be aligned with a side of the first lightly doped region 120 away from the openings.

Refer to FIG. 18. An anisotropic etching process is performed based on the photoresist layer 506 to remove a portion of the polysilicon layer 505D and a portion of the insulating layer 210. The remaining polysilicon layer 505D becomes a P-type second doped region 320 and the second polysilicon structure 212. Specifically, portions of the polysilicon layer 505D covered by the photoresist layer 506 (the second doped region 320) and in the openings O7 (the second polysilicon structure 212) are remained after the etching process. The second polysilicon structure 212 may have a top surface coplanar with the top surface of the first lightly doped region 120. That is, a portion of the polysilicon layer 505D above the top surface of the first lightly doped region 120 and not covered by the photoresist layer 506 is removed.

The insulating layer 210 below the photoresist layer 506 is not etched, and the portion of the insulating layer 210 not covered by the photoresist layer 506 may be partially removed, such that the thickness TH1 of the insulating layer 210 below the second doped region 320 is greater than the thickness TH2 of the insulating layer 210 in the remaining portion. Specifically, a portion of the insulating layer 210 over the top surfaces of the first lightly doped region 120 and the epitaxial layer 110 and not covered by the photoresist layer 506 may be partially removed, with the remaining insulating layer 210 having the thickness TH2. In some embodiments, the thickness TH1 is between about 300 angstroms and about 10,000 angstroms.

After the etching process, the photoresist layer 506 is removed. The polysilicon layer 505D is thus divided into two discontinuous portions after the portion of the polysilicon layer 505D is removed, namely, the second doped region 320 and the second polysilicon structure 212. According to the example manufacturing process described with respect to FIG. 15 to FIG. 18, it can be seen that the second doped region 320 and the second polysilicon structure 212 are formed simultaneously, and have substantially the same material and the same doping concentration.

In certain existing technologies, the upper portion of a trench gate structure is filled with a cap layer, and the cap layer is usually made of oxide or silicate glass. After the cap layer is formed, a planarization process needs to be performed to planarize the surface of the cap layer to facilitate subsequent processes. Embodiments of the present disclosure utilize the step of forming the second doped region 320 in the diode string DS to simultaneously form the second polysilicon structure 212, thereby replacing the cap layer and the step of forming the cap layer. The advantage of this is that it saves the step of forming the cap layer and the step of planarizing the cap layer. In addition, different components in the semiconductor structure 10 are formed simultaneously in the same process, which is equivalent to integrating different steps together, reducing the complexity and cost of the manufacturing processes.

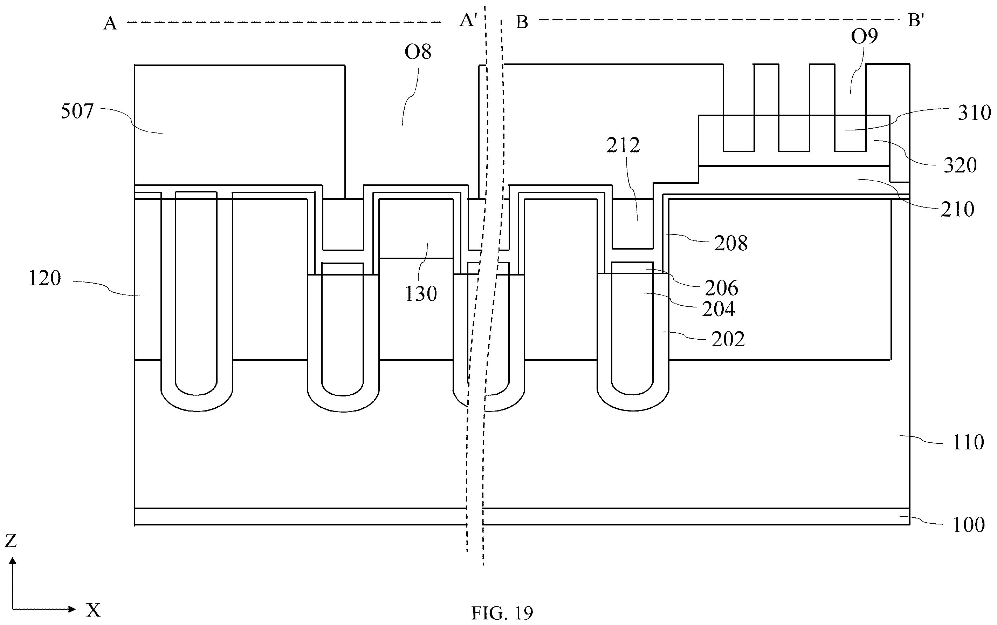

Refer to FIG. 19. A photoresist layer 507 is formed, and an ion implantation process is performed based on the photoresist layer 507 to form the N-type second lightly doped region 130 and the N-type first doped regions 310. The photoresist layer 507 may include an opening O8 and openings O9 exposing part of the structure of FIG. 18. An upper portion of the first lightly doped region 120 that is not covered by the photoresist layer 507 (i.e., the position corresponding to the opening O8) is converted into the second lightly doped region 130 through the ion implantation. The top surface of the second lightly doped region 130 is coplanar with the top surface of the first lightly doped region 120. An upper portion of the second doped region 320 that is not covered by the photoresist layer 507 (i.e., the positions corresponding to the openings 09) is converted into the first doped regions 310. The top surfaces of the first doped regions 310 are coplanar with the top surface of the second doped region 320. It should be noted that in the step of FIG. 19, the bottom surfaces of the first doped regions 310 are higher than the bottom surface of the second doped region 320. After the ion implantation process, the photoresist layer 507 is removed.

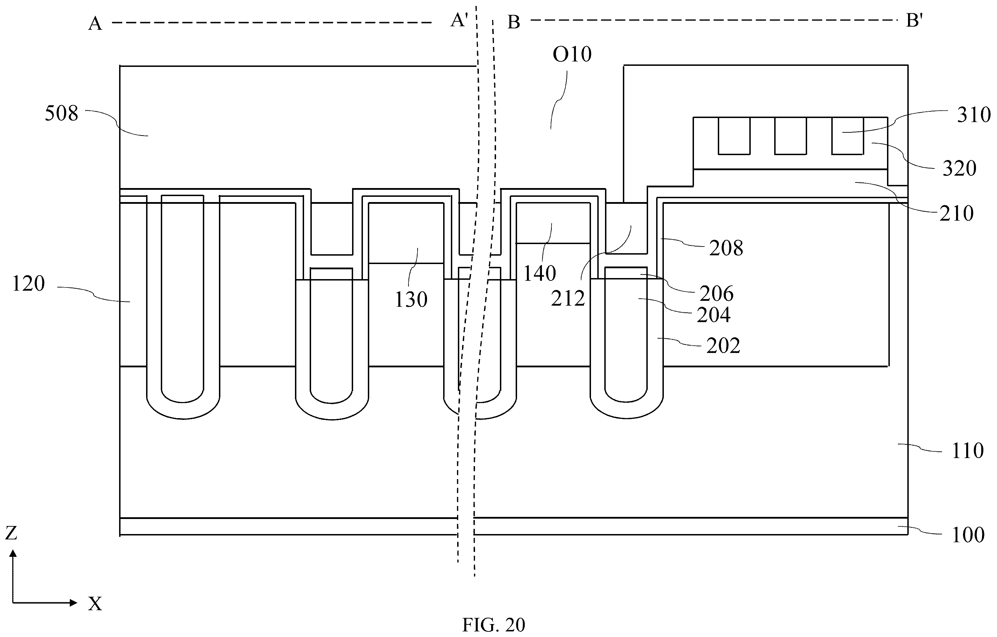

Refer to FIG. 20. A photoresist layer 508 is formed, and an ion implantation process is performed based on the photoresist layer 508 to form the P-type heavily doped region 140. An upper portion of the first lightly doped region 120 that is not covered by the photoresist layer 508 (i.e., the position of an opening O10) is converted into the heavily doped region 140. The top surface of the heavily doped region 140 is coplanar with the top surface of the first lightly doped region 120. The bottom surface of the heavily doped region 140 may be at the same height as the bottom surface of the second lightly doped region 130. The bottom surfaces of the heavily doped region 140 and second lightly doped region 130 may both be higher, in the Z-direction, than the top surface of the gate oxide layer 202 below the second polysilicon structure 212.

In some embodiments, the molecular weight of the doping particles in the second lightly doped region 130 may be smaller than the molecular weight of the doping particles in the heavily doped region 140. In this case, after the ion implantation process, the implantable depth of the doping particles in the heavily doped region 140 is smaller, such that the bottom surface of the heavily doped region 140 is higher than the bottom surface of the second lightly doped region 130. After the ion implantation process, the photoresist layer 508 is removed.

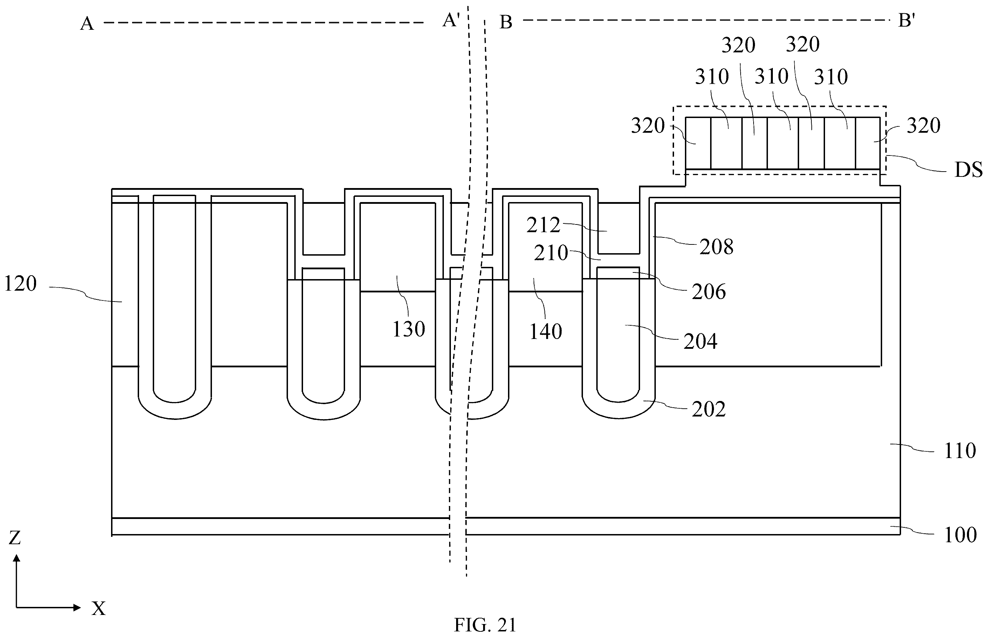

Refer to FIG. 21. An annealing process is performed to cause the depths of the second lightly doped region 130, the heavily doped region 140 and the first doped regions 310 to get close to the substrate 100. After the annealing process, the depths of the first doped regions 310 are close to the substrate 100 and the first doped regions 310 are directly in contact with the insulating layer 210 below the second doped region 320, such that the diode string DS is formed. The annealing process causes the second lightly doped region 130, the heavily doped region 140 and the first doped regions 310 expand toward the substrate 100, such that their depths are increased. The first doped regions 310 thus span the depth of the second doped region 320 in the Z-direction. As a result, the second doped region 320 is divided into multiple regions (referred to as the plurality of second doped regions 320, where the numeral number 320 is reused for illustration convenience) separated by the plurality of first doped regions 310.

In some embodiments, after the annealing process, the bottom surface of the second lightly doped region 130 is coplanar with the bottom surface of the heavily doped region 140. In other embodiments, after the annealing process, the bottom surface of the heavily doped region 140 is closer to the substrate 100 than the bottom surface of the second lightly doped region 130.

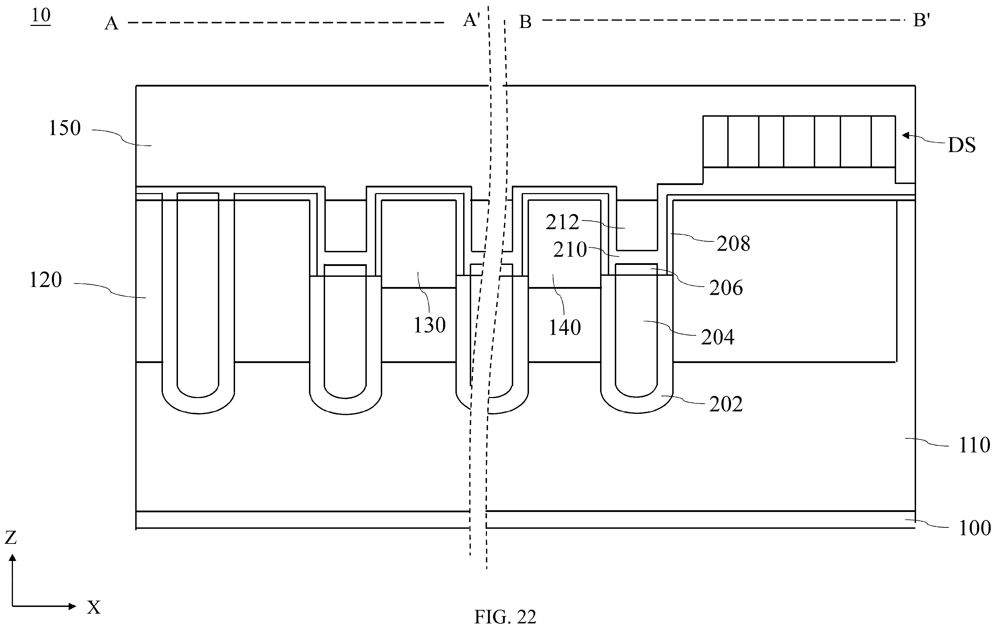

Refer to FIG. 22. The interlayer oxide layer 150 is formed to cover the structure in FIG. 21.

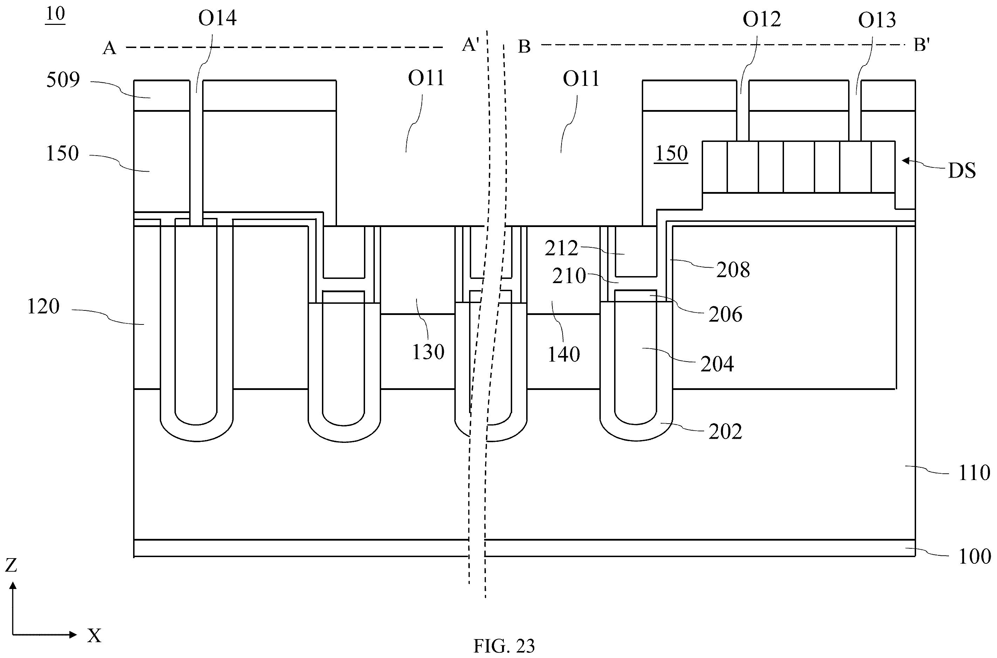

Refer to FIG. 23. A photoresist layer 509 is formed, and an etching process is performed based on the photoresist layer 509 to remove a portion of the interlayer oxide layer 150. The photoresist layer 509 has openings O11, 012, 013, and O14, which respectively define the positions of the source electrode 160, the conductive plug 191, the conductive plug 192, and the conductive plug 194. The etching process removes the portion of the interlayer oxide layer 150 corresponding to the openings O11, 012, 013, and 014. The etching process may also remove portions of the insulating layer 210, the thermal oxide layer 206, and the thermal oxide layer 208 above the top surface of the epitaxial layer 110 and the top surface of the first lightly doped region 120 corresponding to the openings O11 and O14. After the etching process, the photoresist layer 509 is removed.

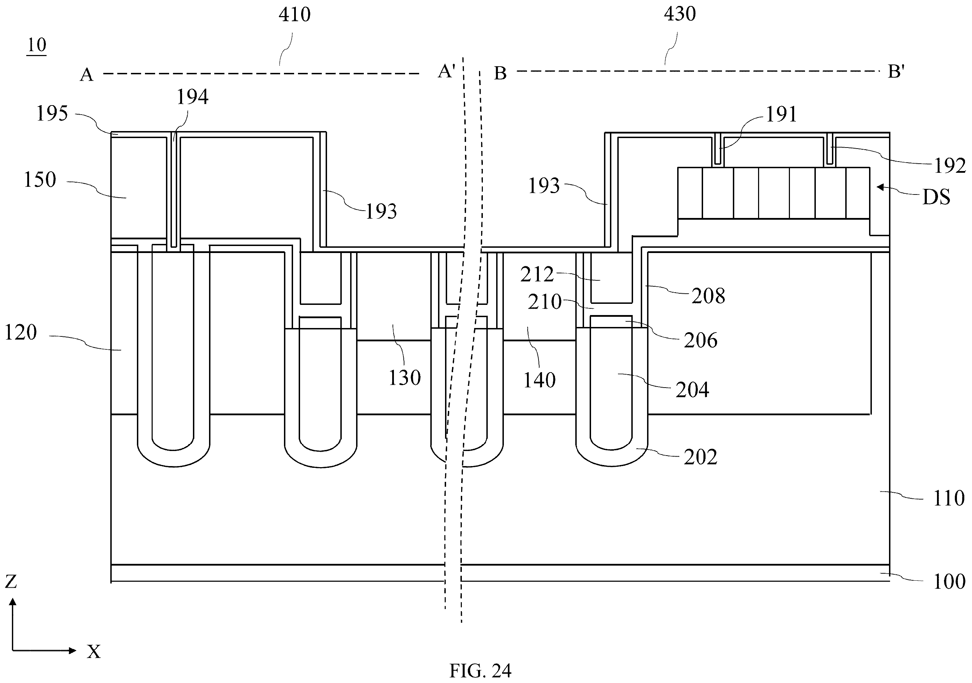

Refer to FIG. 24. The barrier metal layer 195, the conductive plug 191, the conductive plug 192, the metal layer 193, and the conductive plug 194 are formed. In some embodiments, before forming the conductive plug 191, the conductive plug 192, the metal layer 193, and the conductive plug 194, the barrier metal layer 195 is filled in the opening O11, the opening 012, the opening O13, and the opening 014. An etching process may then be performed to remove part of the barrier metal layer 195, where the aspect ratio of the opening O11 is small, and therefore most of the barrier metal layer 195 in the opening O11 is removed, and only the barrier metal layer 195 on the sidewalls and bottom of the opening O11 remains. Since the aspect ratios of the opening 012, the opening 013, and the opening 014 are large, the barrier metal layer 195 in the opening 012, the opening 013, and the opening 014 is partially removed. In some embodiments, the barrier metal layer 195 in the opening 012, the opening 013, and the opening 014 is not removed at all.

The barrier metal layer 195 may further be disposed on the top surface of the interlayer oxide layer 150 with the photoresist layer 509 removed. In some embodiments, portions of the barrier metal layer 195 filled in the openings O11-O14 are removed by the etching process, resulting in a remaining portion of the barrier metal layer 195 covering the sidewalls and the bottom surface of each of the openings O11-O14. In some embodiments, the barrier metal layer 195 filled in the openings O12-O14 are not removed. After the barrier metal layer 195 is formed, the conductive plug 191, the conductive plug 192 and the conductive plug 194 are formed respectively in the openings O12-O14.

In some embodiments, the metal layer 193 may be formed covering the barrier metal layer 195 disposed on the sidewalls of the opening O11.

After forming the barrier metal layer 195, the conductive plug 191, the conductive plug 192, the metal layer 193 and the conductive plug 194, a metal layer may be formed to cover the structure shown in FIG. 24. A patterned photoresist may then be formed, and an etching process may be performed based on the patterned photoresist layer to remove part of the metal layer to form the semiconductor structure 10 shown in FIG. 2 and FIG. 4. The source electrode 160 and the gate electrode 170 are formed.

In other embodiments, the semiconductor structure 10 does not include the barrier metal layer 195.

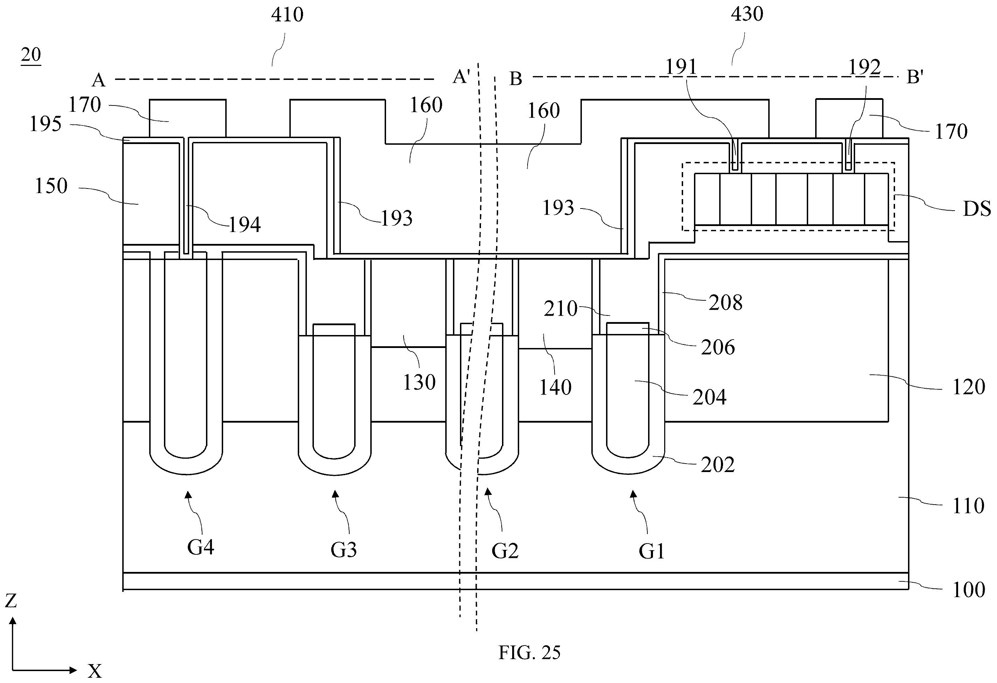

It should be understood that the semiconductor structure 10 of the present disclosure is not limited to the structures described in above embodiments. For example, the second polysilicon structure 212 of the semiconductor structure 10 implemented in different shapes is also within the scope of the present disclosure. Referring to FIG. 25, FIG. 26 and FIG. 27, FIG. 25, FIG. 26 and FIG. 27 are respective schematic diagrams of a semiconductor structure 20, a semiconductor structure 30 and a semiconductor structure 40 according to other embodiments of the present disclosure. For ease of understanding, the symbols in FIG. 25, FIG. 26 and FIG. 27 follow the symbols used in FIG. 1 to FIG. 4, however, this does not mean that the components using the same symbols must be the same.

Referring to FIG. 25, the semiconductor structure 20 is substantially similar to the semiconductor structure 10, except for the second polysilicon structure 212. Specifically, the gate structures G1~G3 of the semiconductor structure 20 do not include the second polysilicon structure 212. The widths (width along the X-direction) of the gate structures G1~G4 of the semiconductor structure 20 is smaller than those of the semiconductor structure 10. When the insulating layer 210 is formed, the gate structures G1~G3 are filled with the insulating layer 210, and there is no remaining space to accommodate the second polysilicon structure 212. Therefore, the semiconductor structure 20 does not include the second polysilicon structure 212.

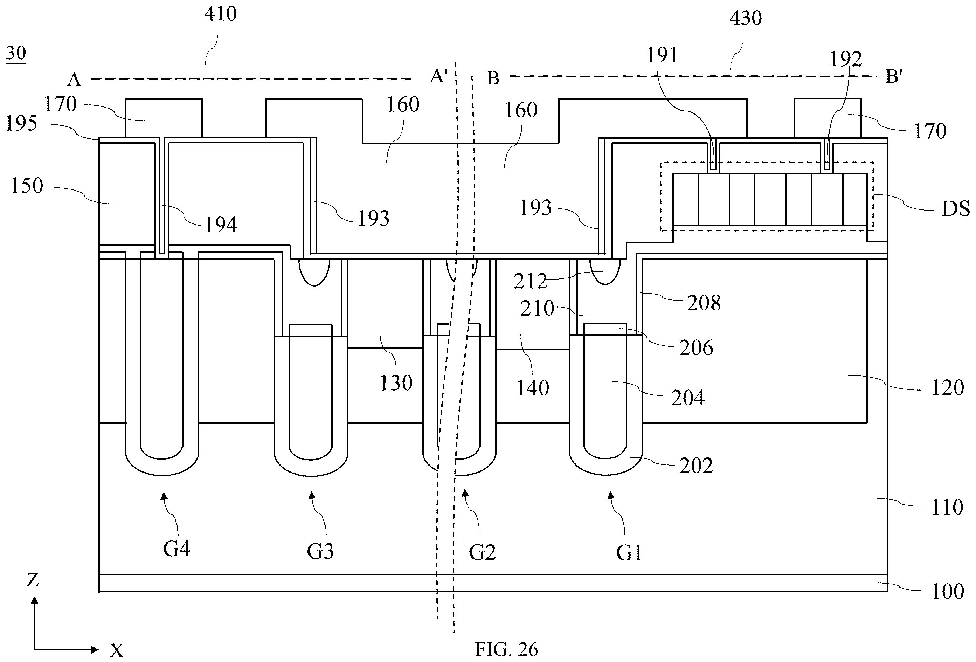

Referring to FIG. 26, the semiconductor structure 30 is substantially similar to the semiconductor structure 10, except that the second polysilicon structure 212 is different. Specifically, in the semiconductor structure 30, the second polysilicon structure 212 has an arc-shaped sidewall adjoining the insulating layer 210 in the gate structures G1~G3. Compared with the semiconductor structure 10, the second polysilicon structure 212 of the semiconductor structure 30 occupies a smaller volume/space. It should be understood that the cross-sectional profile of the second polysilicon structure 212 of the semiconductor structure 30 is related to the spacing between the gate structures G1~G4 and the aspect ratio of the gate structures G1~G4. In some embodiments, the second polysilicon structure 212 of the semiconductor structure 30 may have a triangular cross-sectional profile. In some embodiments, the second polysilicon structure 212 of the semiconductor structure 30 may have a trapezoidal cross-sectional profile that gradually narrows toward the substrate 100. In some embodiments, the second polysilicon structure 212 of the semiconductor structure 30 may have a rectangular cross-sectional profile. In some embodiments, the second polysilicon structure 212 of the semiconductor structure 30 may have a semicircular cross-sectional profile.

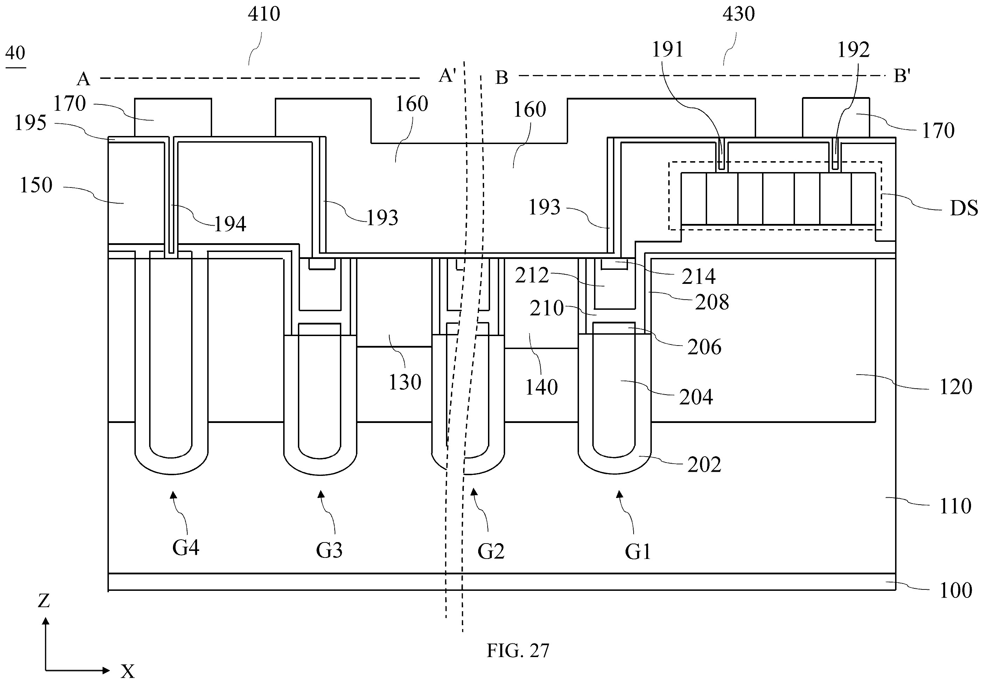

Referring to FIG. 27, the semiconductor structure 40 is substantially similar to the semiconductor structure 10, except that the second polysilicon structure 212 is different. Specifically, when forming the second polysilicon structure 212, polysilicon is filled into the openings O7 (referring to FIG. 14) of the gate structures G1~G3. The polysilicon may be formed by anisotropic deposition, such that after the deposition, the top surface of the polysilicon has a depression substantially similar to the openings O7. In the semiconductor structure 40, the depression on the top surface of the second polysilicon structure 212 may be used to accommodate a filling layer 214. In some embodiments, the filling layer 214 is an oxide, an insulator, or a barrier metal. It should be noted that although the second polysilicon structure 212 has the filling layer 214 on its top surface, the second polysilicon structure 212 is still electrically coupled to and adjoins the source electrode 160.

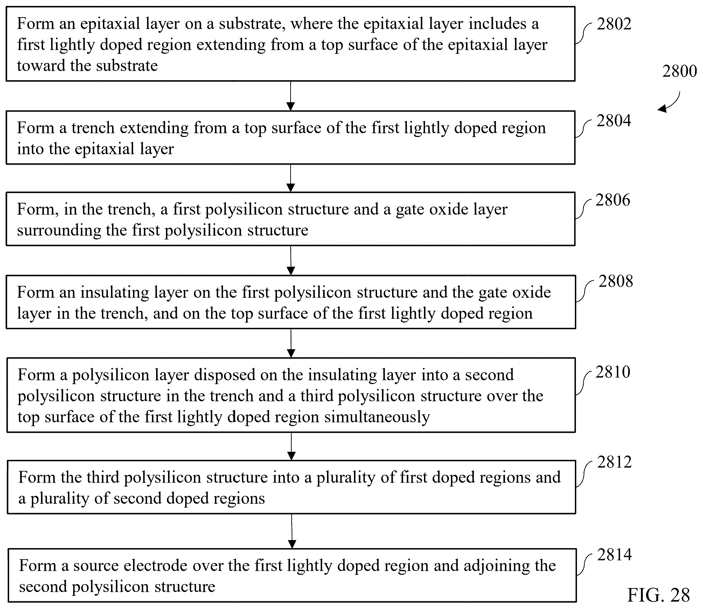

FIG. 28 is a flowchart of a method 2800 of manufacturing a semiconductor structure according to embodiments of the present disclosure. The method 2800 may be representative of operations configured for manufacturing the embodiment semiconductor structure 10, 20, 30 or 40 as described above. As shown, the method 2800 may include forming an epitaxial layer on a substrate, where the epitaxial layer includes a first lightly doped region extending from a top surface of the epitaxial layer toward the substrate (step 2802). A trench may be formed extending from a top surface of the first lightly doped region into the epitaxial layer (step 2804). A first polysilicon structure and a gate oxide layer surrounding the first polysilicon structure may be formed in the trench (step 2806). An insulating layer may be formed on the first polysilicon structure and the gate oxide layer in the trench, and on the top surface of the first lightly doped region (step 2808). A polysilicon layer disposed on the insulating layer may be formed into a second polysilicon structure in the trench and a third polysilicon structure over the top surface of the first lightly doped region simultaneously (step 2810). The third polysilicon structure may be formed into a plurality of first doped regions of a first conductivity type and a plurality of second doped regions of a second conductivity type (step 2812), where the plurality of first doped regions and the plurality of second doped regions are alternately arranged and form a diode string. A source electrode may further be formed over the first lightly doped region and adjoining the second polysilicon structure (step 2814). The method 2800 may also include other operations as described above with respect to the semiconductor structures 10~40.

The following provides further embodiments.

In an embodiment, a semiconductor structure is provided that includes: a substrate; an epitaxial layer on the substrate, wherein the epitaxial layer has a doped region extending from a top of the epitaxial layer toward the substrate; a diode string above the epitaxial layer; a gate structure, at least partially surrounded by the doped region and extending toward the substrate into the epitaxial layer, the gate structure comprising: a first polysilicon structure; a gate oxide layer surrounding the first polysilicon structure; an insulating layer, above the first polysilicon structure and the gate oxide layer, and extending between the doped region and the diode string; and a second polysilicon structure, above the first polysilicon structure and the gate oxide layer and surrounded by the insulating layer, and a source structure, adjoining the doped region and the second polysilicon structure and electrically coupled to the diode string through a first conductive plug.

Optionally, in the preceding embodiment, the doped region comprises: a first lightly doped region; a second lightly doped region, above the first lightly doped region; and a heavily doped region, disposed on the first lightly doped region and surrounded by the second lightly doped region, wherein the source structure adjoins the second lightly doped region and the heavily doped region, and the doping concentration of the second lightly doped region is less than the doping concentration of the heavily doped region and greater than the doping concentration of the first lightly doped region.

Optionally, in any of the preceding applicable embodiments, the second lightly doped region and the heavily doped region are electrically connected to a source electrode and together serve as the source structure.

Optionally, in any of the preceding applicable embodiments, the gate structure further comprises a thermal oxide layer, wherein the thermal oxide layer comprises: a bottom portion above the first polysilicon structure; and a sidewall portion extending between the doped region and the insulating layer.

Optionally, in any of the preceding applicable embodiments, a thickness of the insulating layer is greater than a thickness of the thermal oxide layer.

Optionally, in any of the preceding applicable embodiments, a thickness of the bottom portion is greater than a thickness of the sidewall portion.

Optionally, in any of the preceding applicable embodiments, the bottom portion does not contact the sidewall portion.

Optionally, in any of the preceding applicable embodiments, the diode string comprises: a plurality of first doped regions having a first conductivity type, wherein the first conductive plug adjoins a first end of the plurality of first doped regions; and a plurality of second doped regions of a second conductivity type, wherein the plurality of first doped regions and the plurality of second doped regions are alternately arranged, a PN junction is formed at an interface between each first doped region and an adjacent second doped region.

Optionally, in any of the preceding applicable embodiments, the second polysilicon structure has the second conductivity type.

Optionally, in any of the preceding applicable embodiments, the plurality of second doped regions is made of polysilicon, and a doping concentration of the plurality of second doped regions is same as a doping concentration of the second polysilicon structure.

Optionally, in any of the preceding applicable embodiments, the semiconductor structure further comprises: a gate electrode, above the diode string, electrically coupled to the first polysilicon, and coupled to a second end of the plurality of first doped regions through a second conductive plug.

Optionally, in any of the preceding applicable embodiments, the semiconductor structure further comprises: an interlayer oxide layer, on the insulating layer, surrounding the source structure and the diode string, and covering the diode string.

Optionally, in any of the preceding applicable embodiments, a thickness of the insulating layer on the first polysilicon structure is less than a thickness of a portion of the insulating layer extending between the doped region and the diode string.

Optionally, in any of the preceding applicable embodiments, the thickness of the portion of the insulating layer extending between the doped region and the diode string is between about 300 angstroms and about 10,000 angstroms.

Optionally, in any of the preceding applicable embodiments, the source structure comprises: the first conductive plug; a source electrode; a metal layer disposed on two sides of the source electrode; and a barrier metal layer, surrounding the source electrode, the metal layer and the first conductive plug, and adjoining the doped region, the second polysilicon structure and the diode string.

Optionally, in any of the preceding applicable embodiments, the first conductive plug and the metal layer have a same material.

Optionally, in any of the preceding applicable embodiments, the second polysilicon structure has a rectangular profile in a cross-sectional view.

Optionally, in any of the preceding applicable embodiments, the second polysilicon structure has a triangular profile in a cross-sectional view.

Optionally, in any of the preceding applicable embodiments, in a cross-sectional view, the second polysilicon structure has an arc-shaped sidewall adjoining the insulating layer.

In another embodiment, a method of manufacturing a semiconductor structure is provided that includes: providing a substrate, wherein the substrate has an epitaxial layer thereon, and the epitaxial layer has a first lightly doped region extending from a top of the epitaxial layer toward the substrate; forming a trench extending from a top surface of the first lightly doped region toward the substrate, beyond the first lightly doped region and into the epitaxial layer; forming a gate oxide layer surrounding a first polysilicon structure in the trench; forming an insulating layer above the first polysilicon structure and the gate oxide layer and extending to the top surface of the first lightly doped region; forming a polysilicon layer above the insulating layer, wherein the polysilicon layer fills a remaining space of the trench; removing a portion of the polysilicon layer to simultaneously form a second polysilicon structure in the trench and a third polysilicon structure on the top surface of the first lightly doped region; converting the third polysilicon structure into a plurality of first doped regions having a first conductivity type, a remaining portion of the third polysilicon structure forming a plurality of second doped regions having a second conductivity type, wherein the plurality of first doped regions and the plurality of second doped regions are alternately arranged to form a diode string; forming an interlayer oxide layer on the insulating layer and the second polysilicon structure, surrounding the diode string, and covering the diode string; and forming a source electrode extending through the interlayer oxide layer and adjoining the second polysilicon structure.

Optionally, in the preceding embodiment, the step of converting the portion of the third polysilicon structure into the plurality of first doped regions having the first conductivity type comprise performing an ion implantation process, wherein the step of performing the ion implantation process further converts a first portion of the first lightly doped region into a second lightly doped region, and a doping concentration of the second lightly doped region is greater than a doping concentration of the first lightly doped region.

Optionally, in any of the preceding applicable embodiments, the method may further include converting a second portion of the first lightly doped region into a heavily doped region, wherein the heavily doped region is surrounded by the second lightly doped region, and a top surface of the heavily doped region is coplanar with a top surface of the second lightly doped region.

Optionally, in any of the preceding applicable embodiments, a doping concentration of the heavily doped region is greater than the doping concentration of the second lightly doped region, the second lightly doped region has the first conductivity type, and the heavily doped region and the first lightly doped region have the second conductivity type.

Optionally, in any of the preceding applicable embodiments, the source electrode adjoins the second lightly doped region and the heavily doped region.

Optionally, in any of the preceding applicable embodiments, the method may further include forming a gate electrode on the interlayer oxide layer, wherein the source electrode is electrically coupled to a first end of the plurality of first doped regions, and the gate electrode is electrically coupled to a second end of the plurality of first doped regions.

Optionally, in any of the preceding applicable embodiments, the step of removing the portion of the polysilicon layer comprises performing an anisotropic etching process, wherein the step of performing the anisotropic etching process further removes a portion of the insulating layer.

Optionally, in any of the preceding applicable embodiments, after the step of performing the anisotropic etching process, a thickness of the insulating layer below the third polysilicon structure is greater than a thickness of the insulating layer not covered by the third polysilicon structure.

Optionally, in any of the preceding applicable embodiments, the method may further include, before forming the insulating layer, performing a thermal oxidation process to form a thermal oxidation layer on the first polysilicon structure and the first lightly doped region.

Optionally, in any of the preceding applicable embodiments, the step of performing the thermal oxidation process comprises: consuming a portion of the first polysilicon structure to form a bottom portion of the thermal oxide layer; and consuming a portion of the first lightly doped region to form a sidewall portion of the thermal oxide layer.

Optionally, in any of the preceding applicable embodiments, the bottom portion does not contact the sidewall portion, and the insulating layer is at least partially not covered by the thermal oxide layer.

Optionally, in any of the preceding applicable embodiments, the insulating layer is formed in a manner different from the thermal oxidation process.

In this disclosure, for description convenience, spatially relative terms such as "below", "under", "lower", "above", "upper", "left side", "right side", and so on, may be used to describe the relationship of one component or feature with another one or more components or features, as shown in the accompanying drawings. The spatially relative terms are not only used to depict the orientations in the accompanying drawings, but also intended to encompass different orientations of a device in use or operation. A device may be oriented in other ways (rotated 90 degrees or in other orientations), and the spatially relative terms used herein may be interpreted in a corresponding way similarly. It should be understood that when a component is referred to as being "connected" or "coupled" to another component, it can be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of the endpoints unless otherwise indicated. The term "substantially coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "substantially" the same, the term may refer to a value that is within ±10%, ±5%, ±1%, or ±0.5% of the mean of the values.

The foregoing has outlined features of some embodiments and detailed aspects of present disclosure. The embodiments described in the present disclosure may be readily used as a basis for designing or modifying other processes and structures in order to carry out the same or similar purposes and/or to achieve the same or similar advantages of the embodiments presented herein. Such equivalent constructions do not depart from the spirit and scope of the present disclosure, and various changes, substitutions, and alterations can be made without departing from the spirit and scope of the present disclosure.

Although the description has been described in detail, it should be understood that various changes, substitutions and alterations can be made without departing from the spirit and scope of this disclosure as defined by the appended claims. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, which may perform substantially the same function or achieve substantially the same result as the corresponding embodiments described herein, may be utilized according to the present disclosure. Accordingly, the appended claims are intended to include within their scope such processes, machines, manufacture, compositions of matter, means, methods, or steps.

## Claims

1. A semiconductor structure comprising:
an epitaxial layer on a substrate, the epitaxial layer comprising a doped region extending from a top surface of the epitaxial layer into the epitaxial layer;
a diode string over the epitaxial layer; and
a gate structure, extending from the top surface of the epitaxial layer into the epitaxial layer passing through the doped region, the gate structure comprising:
a first polysilicon structure;
a gate oxide layer surrounding the first polysilicon structure;
a second polysilicon structure over the first polysilicon structure and the gate oxide layer; and
an insulating layer, comprising:
a first portion surrounding the second polysilicon structure, between the second polysilicon structure and the first polysilicon structure, and in contact with the gate oxide layer, and
a second portion extending between the top surface of the epitaxial layer and the diode string.

2. The semiconductor structure of claim 1, wherein the doped region comprises:
a first lightly doped region;
a second lightly doped region in the first lightly doped region; and
a heavily doped region, disposed in the first lightly doped region and surrounded by the second lightly doped region; and
wherein a doping concentration of the second lightly doped region is less than a doping concentration of the heavily doped region and greater than a doping concentration of the first lightly doped region, and the second lightly doped region and the heavily doped region are electrically connected to a source electrode, and serve with the source electrode as a source structure of the semiconductor structure.

3. The semiconductor structure of claim 1 or 2, wherein the gate structure further comprises a thermal oxide layer, and the thermal oxide layer comprises:
a first portion on the first polysilicon structure; and
a second portion extending between the top surface of the epitaxial layer and the second portion of the insulating layer,
wherein the first portion of the thermal oxide layer is not in contact with the second portion of the thermal oxide layer.

4. The semiconductor structure of claim 3, wherein a thickness of the first portion of the thermal oxide layer is greater than a thickness of the second portion of the thermal oxide layer.

5. The semiconductor structure of any one of preceding claims, wherein the diode string comprises:
a plurality of first doped regions of a first conductivity type; and
a plurality of second doped regions of a second conductivity type; and
wherein the plurality of first doped regions and the plurality of second doped regions are alternately arranged, and a PN junction is formed at an interface between each first doped region and an adjacent second doped region.

6. The semiconductor structure of claim 5, wherein the plurality of second doped regions is made of polysilicon, and a doping concentration of the plurality of second doped regions is same as a doping concentration of the second polysilicon structure.

7. The semiconductor structure of any one of preceding claims, wherein a thickness of the first portion of the insulating layer on the first polysilicon structure is less than a thickness of the second portion of the insulating layer.

8. A method comprising:
forming an epitaxial layer on a substrate, the epitaxial layer comprising a first lightly doped region extending from a top surface of the epitaxial layer toward the substrate;
forming a trench extending from a top surface of the first lightly doped region into the epitaxial layer;
forming, in the trench, a first polysilicon structure and a gate oxide layer surrounding the first polysilicon structure;
forming an insulating layer on the first polysilicon structure and the gate oxide layer in the trench, and on the top surface of the first lightly doped region;
forming a polysilicon layer disposed on the insulating layer into a second polysilicon structure in the trench and a third polysilicon structure over the top surface of the first lightly doped region simultaneously;
forming the third polysilicon structure into a plurality of first doped regions of a first conductivity type and a plurality of second doped regions of a second conductivity type, the plurality of first doped regions and the plurality of second doped regions being alternately arranged and forming a diode string; and
forming a source electrode over the first lightly doped region and adjoining the second polysilicon structure.

9. The method of claim 8, wherein forming the polysilicon layer disposed on the insulating layer into the second polysilicon structure in the trench and the third polysilicon structure over the top surface of the first lightly doped region comprises:
forming the polysilicon layer on the insulating layer covering the trench and the first lightly doped region;
disposing a mask on the polysilicon layer; and
removing a portion of the polysilicon layer that is above the top surface of the first lightly doped region and not covered by the mask, a first remaining portion of the polysilicon layer in the trench forming the second polysilicon structure, and a second remaining portion of the polysilicon layer covered by the mask forming the third polysilicon structure.

10. The method of claim 9, removing the portion of the polysilicon layer comprises:
performing an anisotropic etching process to remove the portion of the polysilicon layer, wherein the anisotropic etching process further removes a portion of the insulating layer not covered by the mask.

11. The method of any one of claims 8 to 10, wherein a top surface of the insulating layer in the trench is lower than the top surface of the first lightly doped region, and the insulating layer is further formed on a portion of sidewalls of the trench above the first polysilicon structure and the gate oxide layer.

12. The method of any one of claims 8 to 11, wherein forming the third polysilicon structure into the plurality of first doped regions and the plurality of second doped regions comprises:
performing an ion implantation process to form a portion of the third polysilicon structure into the plurality of first doped regions, with a remaining portion of the third polysilicon structure forming the plurality of second doped regions.

13. The method of claim 12, wherein performing the ion implantation process further forms a first portion of the first lightly doped region into a second lightly doped region, a doping concentration of the second lightly doped region being greater than a doping concentration of the first lightly doped region.

14. The method of claim 12 or 13, further comprises:
forming a second portion of the first lightly doped region into a heavily doped region, wherein the heavily doped region is surrounded by the second lightly doped region, and a top surface of the heavily doped region is coplanar with a top surface of the second lightly doped region.

15. The method of any one of claims 8 to 14, further comprising:
forming a gate electrode over the first lightly doped region, wherein the source electrode is electrically coupled to a first end of the plurality of first doped regions, and the gate electrode is electrically coupled to a second end of the plurality of first doped regions.
